(19) Europäisches Patentamt / European Patent Office / Office européen des brevets

(11) EP 1 246 206 B1

(12) **EUROPEAN PATENT SPECIFICATION**

(45) Date of publication and mention of the grant of the patent:
**28.02.2007 Bulletin 2007/09**

(51) Int Cl.:
***H01B 1/22*** *(2006.01)* ***C09J 163/00*** *(2006.01)*
***H01R 4/04*** *(2006.01)* ***H05K 3/32*** *(2006.01)*

(21) Application number: **02012317.0**

(22) Date of filing: **14.11.1990**

(54) **Moisture resistant electrically conductive cements and method for the production and using same**

Feuchtigkeitsbeständige elektrisch leitfähige Zemente und Methode zur Herstellung und Anwendung derselben

Ciments electroconducteurs resistant à l humidité et leurs procédés de fabrication et d utilisation

(84) Designated Contracting States:
**AT BE CH DE DK ES FR GB GR IT LI LU NL SE**

(30) Priority: **14.11.1989 US 436199**
**04.06.1990 US 533682**
**01.11.1990 US 607554**

(43) Date of publication of application:
**02.10.2002 Bulletin 2002/40**

(62) Document number(s) of the earlier application(s) in accordance with Art. 76 EPC:
**90121829.7 / 0 428 165**

(73) Proprietor: **POLY-FLEX CIRCUITS, INC.**
**Cranston, RI 02920 (US)**

(72) Inventors:
- **Durand, David**
**Providence, R.I. 02906 (US)**
- **Vieau, David P.**
**East Greenwich, RI 02818 (US)**
- **Wei, Tai Shing**
**Cranston**
**Rhode Island 02920 (US)**
- **Chu, Ang-Ling**
**Cranston,**
**Rhode Island 02920 (US)**

(74) Representative: **UEXKÜLL & STOLBERG**
**Patentanwälte**
**Beselerstrasse 4**
**22607 Hamburg (DE)**

(56) References cited:
**DE-A- 1 933 383** **US-A- 4 487 811**
**US-A- 4 747 968**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 246 206 B1

Printed by Jouve, 75001 PARIS (FR)

**Description**

FIELD OF THE INVENTION

The present invention relates to electrically conductive cements or adhesives and, more particularly, to electrically conductive cements having superior long-term performance in high temperature and high humidity environments.

BACKGROUND OF THE INVENTION

Electrically conductive cements and adhesives are typically fabricated from single- or multi-component non-conductive carrier materials and conductive fillers such as metal or metallic particulate. While various cements can be used as the carrier, multi-component epoxies, single-component solvent-based systems, and combinations thereof have been used. Epoxies have a long shelf life, good bonding properties and can be cured with many materials. Similarly, single-component solvent-based systems can be readily cured by driving off the solvent to form a strong and reliable bond with many materials. The fillers are typically noble metals, such as, gold or silver, in various particulate sizes. A preferred filler is a mixture of flake-like and non-flake particles of various sizes. The particles can be essentially solid or, in some cases, metal-plated non-conductive bodies. In a typical formulation, the conductive filler can comprise approximately 75% by weight, or more, of the total material with the carrier comprising the remaining material. It has been thought that metal or metal-plated particles in the form of flakes or platelets provide the bulk conductivity characteristics of such conductive cements because the flakes tend to align themselves in a continuous overlapping relationship in the cured carrier to provide an electron pathway. Non-flake conductive fillers in the carrier are thought to fill interstices between the flake particles providing enhanced conductivity.

Modern electric circuits may be fabricated as traditional rigid printed circuit boards (PCBs) using a subtractive process in which copper traces and connection pads form circuits which are etched from a copper foil layer attached to a rigid, non-conductive board or substrate. Electrical components are connected to such circuits by passing their usually solder-plated leads through mounting holes in the board and connecting the leads to connection pads by lead/tin soldering. It is also known to fabricate so-called 'flex circuits' in which copper traces and connection pads are formed on a flexible layer or substrate of, e.g., polyimide or polyester sheet, such as KAPTON™ polyimide in the 1 to 5 mil thickness range. Electronic components are connected to such circuits by passing their leads through mounting holes in the flexible layer and connecting the leads to connection pads by lead/tin soldering. More recently, surface-mount components (SMC) have been developed in which the component leads are merely positioned upon connection pads and soldered into place forming a butt joint. Surface-mount technology can be used with both rigid and flexible substrates.

Traditional soldered-connection systems represent highly developed technologies with proven performance under various temperature and humidity conditions, particularly higher-temperature and higher-humidity conditions. However, traditional soldered-connection systems often involve extensive chemical processing with various types of etchants and similar chemicals to fabricate a circuit on a substrate and may also require various fluxes and solvents to effect soldered connections. Additionally, traditional soldered-connection systems involve the application of a substantial amount of heat to momentarily melt the solder material to effect the connection. While rigid substrates and certain relatively high-cost polyimides are designed to accommodate the heat of soldering, flexible substrates that use the lower cost polymers such as polyesters are more susceptible to heat damage because of their relatively thin cross-section, low-heat capacity, and susceptibility to distortion. For example, soldered connections on a flexible polyester substrate can cause local 'puckering' of the substrate, changes in the center-to-center dimensions of the various connection pads, and warpage of the entire substrate.

Efforts have been made to use electrically conductive inks, cements, and adhesives to replace traditional soldered-connection systems in both rigid and flexible substrate applications. For example, electrically conductive ink circuits, including connection pads, have been printed on flexible polyester substrate and the conductive terminals of SMC devices then cemented to the connection pads with electrically conductive cement. Advantageously, the resulting flexible printed circuit can be easily configured to fit into a particular mounting envelope providing enhanced design flexibility. In addition, it is estimated that a successful solderless-connection system utilizing conductive inks, cements, and low-cost flexible substrates could provide significant cost savings over traditional soldered-connection systems. The term 'conductive cement' as used herein means any composition or material used to establish electrical contact and a mechanical connection of separate bodies, e.g., a lead and a connection pad.

While conventional electrically conductive cements do not ordinarily possess the conductivity of solid metals and solder alloys, their conductivity (for example, 100 milli-ohm per cemented connection compared to 10 milli-ohm per soldered connection) is adequate for many electrical circuits. For example, a junction resistance of one ohm or so between a component lead and its connection pad will have little effect where the component is a resistor or other device having a resistance or impedance of several hundred or thousand ohms or greater. While junction resistance becomes more important in low-impedance circuit applications, a circuit can usually be designed to accommodate a wide range of cumulative junction resistances. In addition to the quantitive aspect of junction resistance, stability or small changes in junction resistance with time and environment is also an important aspect. A connection system that provides connections having a known resistance that is stable over time and under different environmental conditions is desirable because a connection system that does not provide the requisite stability would be unsuitable for many applications. In the context of a solderless connection system employing electrically conductive cement, any connection which on average exhibits less than about 20 to 25%, and preferably less than about 15% change in junction resistance after 1000 hours of exposure to 90% Relative Humidity (R.H.) at 60°C, is generally considered acceptable. The terms 'moisture resistant cement' and 'moisture resistant electrical contact' as used herein refer to a conductive cement that provides connections having stable junction resistance that on average does not change more than about 25%, under the test conditions described herein, i.e., after about 1000 hours exposure to 90% R.H., at 60°C.

One factor that affects the electrical conductivity at a junction interface is the presence or absence of non-conductive or resistive surface oxides that form as a consequence of exposure of the surfaces to be joined to ambient air and moisture. In soldered-connection systems, oxides are largely removed at the interfacial boundary between the solder-plated lead and the solder itself by fluxes that react with and effectively remove the oxides and which also serve to shield the junction interface from the ambient atmosphere and moisture as the solder cools. In conductive cement connection systems fluxes are not present during the curing process; and, therefore, it is desirable that the cement include means for reducing the adverse effects of surface oxides without the need to treat the surfaces to be connected, e.g., leaded electrical component leads, with aggressive cleaning agents or other treatments prior to effecting the connection.

While the initial bulk resistivity of known silver-based conductive cements is adequate, such cements are susceptible to increases in their resistivity at the interfacial boundary with a soldered-plated lead due to non-conductive lead/tin oxides. Thus the resistance across the junction between a conductive cement and a soldered-plated lead can vary considerably over time particularly with exposure to high humidity. The resistance of such connections is particularly sensitive to continued exposure to combinations of high humidity and high temperature. Since the above-described single- or double-component polymeric carriers used in conventional conductive cements are inherently permeable to moisture, the connections made with such cements are to some extent subject to the adverse effects of moisture. While a circuit can be designed to accommodate cumulative junction resistance, changes in that resistance with time can have a detrimental effect on the circuit's overall electrical performance. It is believed that moisture which permeates the carrier, in a connection formed with conductive cement, oxidizes metal at the interfacial boundary between the conductive cement and the component lead and the resultant non-conductive oxides tend to increase resistance.

Conductive cement compositions known in the art are typically comprised of polymeric carriers filled with conductive particles. For example, U.S. Patent No. 4,880,570 describes a mixture of epoxy based adhesive, catalyst and conductive particles shaped to minimize steric interference and provide conductivity; U.S. Patent No. 4,859,364 describes a mixture of organic medium filled with conductive particles of 0.3 to 1.0 micrometer and conductive metal coated particles of not more than 1 micrometer; U.S. Patent No. 4,859,268 describes a mixture of photosensitive epoxy polymer, plasticizer and spherical electrically conductive particles; U.S. Patent No. 4,814,040 describes an adhesive layer including conductive particles sized to penetrate a resistance layer and invade a metallic pattern by a thermal compressions process; U.S. Patent No. 4,732,702 describes a mixture of resin filled with electroconductive metal powder or an inorganic insulating powder coated with electroconductive film; U.S. Patent No. 4,716,081 describes a mixture of plastic, rubber or resin filled with silver-surfaced metal particles; U.S. Patent No. 4,701,279 describes a mixture of thermoplastic elastomer filled with metal particles; U.S. Patent No. 4,696,764 describes a mixture of resin filled with both abrasive and fine conductive particles; U.S. Patent No. 4,624,801 describes a mixture of polyester urethane based polymer admixed with a blocked isocyanate and filled with conductive particles; U.S. Patent No. 4,747,968 describes a mixture of epoxy resin, hardener and metallic silver particles; U.S. Patent No. 4,564,563 describes a mixture of acrylic, carboxylated vinyl and epoxy polymer filled with metallic silver particles; and U.S. Patent No. 4,566,990 describes a mixture of thermoplastic condensation polymer filled with both metal flake and conductive metal or metal coated fiber.

In general, conductive cements based on silver-filled polymeric systems perform well over a reasonably large temperature range but do not tend to perform well at the interfacial boundary between the cement and electrical leads under high humidity conditions. When aged under high humidity conditions, the resistance across the interfacial boundary is usually unstable, i.e., increases significantly. While many circuits can operate adequately with such increases in the resistivity in one or more of their connections, the humidity sensitivity is considered a factor limiting more widespread use of conductive cements in both rigid and flexible substrate applications.

## SUMMARY OF THE INVENTION

In view of the foregoing, it is an object of the present invention to provide a conductive cement having improved performance characteristics, particularly under high humidity and/or temperature conditions and when used to connect high pin count, surface mount devices, and other electronic components which utilize ordinary metal finishes such as solder plate and tin plate, to a substrate.

It is another object of the present invention to provide a moisture resistant conductive cement in which the volumetric shrinkage of a carrier contributes to the formation of the electrical connection by enhancing particle-to-particle conduction and establishing a gas-tight surface contact between the filler particles and surfaces to be connected.

It is still another object of the present invention to provide an electrically conductive cement including conductive particles dispersed in a carrier and having surface characteristics and sized to assist in establishing gas-tight surface contact between the filler particles and surfaces to be connected due to volumetric shrinkage of the carrier upon curing.

The present invention provides an electrically conductive cement for adhering and establishing electrical contact between the adhered surfaces comprising a mixture of a filler dispersed in an adhesive carrier that shrinks upon curing, said carrier being provided in an amount effective to adhere said mixture to a substrate and said filler being comprised of electrically conductive particles in an amount and having a morphology effective to provide a moisture resistant electrical contact upon curing of the carrier.

The present invention also provides a method for making moisture resistant electrical connections, comprising the steps of applying to a surface a mixture of an adhesive carrier that shrinks upon curing and a filler comprised of electrically conductive particles in an amount and having a morphology effective to provide a moisture resistant electrical contact with the substrate.

The present invention provides an electrically conductive cement comprised of a curable polymeric carrier that volumetrically shrinks between its as applied uncured state and its cured state by an amount greater than about 6.8% and preferably between the ranges of about 7.5% and 65%; and a filler comprised of conductive particles effective to provide a moisture resistant electrical contact upon curing of the carrier.

While not wishing to be bound by any particular theory of invention or mode action it is believed that the use of a carrier or binder having a volumetric shrinkage characteristic between the uncured and cured states of greater than about 6.8% appears to effect a measure of a compaction to filler particles dispersed therein and provided in the proper amount and having the proper morphology to both cause the particles to be forced into enhanced electrical contact with each other and to form a gas-tight seal with the surfaces to be connected. It is believed that the shrinkage of the carrier during curing places the interior particles under compression with sufficient force to urge the particles into engagement with one another, as well as, to cause particles at the interface between the cement and surface to be connected, and to penetrate contaminants and non-conductive oxides that may be present on the surface. The particles are provided in an amount relative to the carrier and have morphology surface characteristics and body-size which, when subjected to the compressive forces resulting from the volumetric shrinkage of the carrier upon curing is effective to produce a gas-tight connection with the surface. Gas-tight connection with a lead surface is believed to be verified when a connection is mechanically pulled apart at the interfacial boundary to reveal conductive particles projecting from the cured cement surface. Moisture resistant electrical contact is believed to be the result of a gas-tight seal formed by the projecting particles pressing against the lead surface.

The carrier employed in the cements of this invention can be any material that can be filled with the conductive particles and shrinks sufficiently upon curing while providing adequate cohesive and adhesive strength to make a mechanically secure connection. The carrier may comprise a solvent-based polymeric system or form a mixture of two polymeric carriers, one having a high volumetric shrinkage characteristic and the other having a low volumetric shrinkage characteristic, with the weight percentage of the two components in the mixture being varied so as to provide a volumetric shrinkage characteristic of the mixture in the effective range.

In one embodiment of the present invention, the conductive filler particles are agglomerates having a diameter in a 10.6 micrometer to about 2.00 micrometer distribution range (with a mean size of about 4.5 micrometer) and having rough external appearance characterized by numerous recesses and ridge-like boundaries or salients and a length, width, and depth aspect ratio of approximately 1:1:1. The surface roughness characteristic of such agglomerates is believed to contribute to formation of the moisture resistant electrical contact and penetration of surface oxides or contaminants at a lead surface when the cement undergoes volumetric contraction during curing. Agglomerates are suitable electron carriers since their external surface characteristics can participate in forming moisture resistant electrical contacts between, for example, particles, the conductive leads of an electrical component, and a connection pad on a substrate. In alternative embodiments the moisture resistant electrical contact can be made with other particles called "surface penetrating particles" for purposes of this application including solid and metal-plated particles, that have characteristics similar to the above-described agglomerates, including size and rough surface characteristics.

In a preferred embodiment, the carrier comprises a mixture of two epoxy resins and some nonreactive diluent with a proportion of each component adjusted to provide a volumetric shrinkage between the uncured and cured carrier greater than about 6.8%, more preferably, about 7.5 to 65%.

If desired, a wetting agent may be provided in an amount effective to enhance the wetting ability of the uncured epoxy resin mixture during its application (typically less than 2-5% weight percent of the carrier).

In this preferred embodiment the conductive particle filler is an admixture of silver flakes, silver powder, and silver agglomerates. The agglomerates are irregularly shaped particles having multiple surface indentations and recesses that produce many rough-edged salients or ridges and have a particle length, width, and thickness aspect ratio of about 1:1:1. Silver and silver-plated particles are preferred because silver oxides are conductive in contrast to the insulating oxides of other materials; gold, palladium, and other noble metals also perform well under these conditions but provide an extreme price penalty. Nickel has demonstrated effective stability under high temperature and high humidity conditions, but exhibits higher initial resistance. In effective amounts the agglomerates appear to penetrate non-conducting oxides on surfaces to be connected, such as lead/tin coated leads, when establishing a cemented connection. In general, about 60 to 90 weight percent, preferably about 75 weight percent, of the epoxy resin mixture/conductive filler particle combination is filler particles.

The above and other objects and the further scope of applicability of the present invention will become apparent from the detailed description to follow, taken in conjunction with the accompanying drawings.

BRIEF DESCRIPTION OF THE DRAWINGS

FIG. 1 (Prior Art) is a table demonstrating the increase in junction resistance with exposure to 90% relative humidity conditions of a prior art formulation;

Fig. 2 is a photomicrograph of silver agglomerates utilized in the formulation of Example II at 5000X magnification and illustrating the many rough surface characteristics;

FIG. 3A is a table demonstrating the stability of the junction resistance upon exposure to 90% relative humidity conditions of a formulation prepared in accordance with Example II of the present invention in which the electrical leads were cleaned with acetone prior to effecting the connection;

FIG. 3B is another table demonstrating the stability of junction resistance upon exposure to 90% relative humidity conditions of the formulation of Example II of the present invention in which the electrical leads were cleaned with an inorganic acid prior to effecting the connection;

FIG. 4 is another table demonstrating the stability of junction resistance upon exposure to 90% relative humidity conditions of the formulation of Example III;

FIG. 5 is another table demonstrating the stability of junction resistance upon exposure to 90% relative humidity conditions of the formulation of Example IV;

FIG. 6 is another table demonstrating the improved junction resistance upon exposure to 90% relative humidity conditions of the formulation of Example V;

FIG. 7 is another table demonstrating the stability of junction resistance upon exposure to 90% relative humidity conditions of the formulation of Example VI;

FIG. 8 is another table demonstrating the stability of junction resistance upon exposure to 90% relative humidity conditions of the formulation of Example VII;

FIG. 9 is another table demonstrating the stability of junction resistance upon exposure to 90% relative humidity conditions of the formulation of Example VIII;

FIG. 10 is another table demonstrating the stability of junction resistance upon exposure to 90% relative humidity conditions of the formulation of Example IX;

FIG. 11 is another table demonstrating the stability of junction resistance upon exposure to 90% relative humidity conditions of the formulation of Example X;

FIG. 12 is another table demonstrating the stability of junction resistance upon exposure to 90% relative humidity conditions of the formulation of Example XI;

FIG. 13 is another table demonstrating the stability of junction resistance upon exposure to 90% relative humidity conditions of the formulation of Example XII; and

FIG. 14 is another table demonstrating the stability of junction resistance upon exposure to 90% relative humidity conditions of the formulation of Example XIII.

DETAILED DESCRIPTION OF THE INVENTION

A number of factors must be considered in developing a conductive cement having improved performance characteristics under adverse operating conditions, particularly high humidity and temperature conditions. Since all polymeric carriers are moisture permeable to some extent the conductive particle filler must be such that formation of non-conductive oxidation products is minimal with continued exposure to humidity. Additionally, the carrier should have characteristics that enhance electrical conduction at the interfacial boundary between the cement and the surface of the electrical lead as well as conduction between the conductive particles of the filler; to this end, a silver particle or a silver-plated particle filler is preferred, although other noble metals and nickel are suitable as well.

The various formulations in accordance with the present invention presented below utilize fillers which are silver agglomerates, particles, flakes, and powders as well as silver-plated particles. The agglomerates are characterized by an irregular body-shape and a surface with many recesses that define projecting salients or ridges at the boundaries between the recesses. These agglomerates are preferably characterized as having a length, width, and thickness aspect ratio of approximately 1:1:1 and, as a consequence, are believed to function as force vectors which can form a gas-tight seal and pierce oxides present at a connection interface to maintain stable electrical contact even when subjected to elevated temperatures and humidities. The plated particles employed are in the form of non-conductive inorganic spheroids plated with silver as well as silver coated non-noble metals such as nickel. The agglomerates and the plated particles are believed to form the primary electron conduction path in the cured carrier by direct surface-to-surface inter-particle contact and to participate in contacting and penetrating the surface of the electrical lead surface to be connected, in response to the compaction that results from the volumetric shrinkage of the polymeric carrier. The smaller-sized silver particles, characterized herein as powders, assist in providing interstitial conduction paths between the larger-sized particles. The smaller powder particles, as in the case of the larger agglomerates or particles, can function singly or in groups, to penetrate any oxides or surface contaminants present at the interfacial surface between the cement and the component lead at the junction in response to the internal forces caused by volumetric shrinkage of the carrier.

While the agglomerates and powder particles having the described morphology in effective amounts and combined with the described carrier provide moisture resistant electrical contact, flake-like or platelet-like conductive particles have also been found useful. Flake-like particles are defined as particulates having a thickness dimension which is substantially (i.e., an order or magnitude) smaller than its length and width. In effective amounts, the flake-like particles tend to preferentially overlap or overlay one another in an aligned relationship enhancing the conductivity of the system.

The carrier possesses a volumetric shrinkage characteristic greater than about 6.8% in order to assure internal compaction of the conductive particle filler. Additional characteristics of the carrier can include good adhesion, wettability, and good handling. Since many conductive cements are applied by screenprinting, stencil or similar techniques, the uncured polymeric carrier should have a viscosity which provides a final conductive cement suitable for application by such processes. Carrier rheological properties should be effective for stenciling, screen printing, or pneumatic deposition processes commonly used for applying conductive cement. Suitable viscosities may range from 50,000 to 25,000 cps.

The following examples are representative formulations for conductive cements that provide moisture resistant electrical contacts.

Linear shrinkage values were determined by applying a line of the uncured adhesive to a flat surface, curing the adhesive, and determining shrinkage as a function of the uncured and cured line lengths. Volumetric shrinkage characteristics between the uncured and the cured cement were determined by the following protocol:

The density $\rho_u$ of the uncured (carrier) epoxy solution was determined at room temperature by determining the weight W of an epoxy-filled container of known volume V and known empty weight w as follows:

$$\rho_u = (W-w)/V \qquad \text{Eq. 1}$$

The density $\rho_c$ of the cured epoxy was determined in accordance with the Archimedean principle (ASTM C693) at room temperature using METTLER density determination kit E-210250 and an OHAUS precision balance 160D. The dry weight A of the cured epoxy specimen in air is determined and its weight P in a liquid of known density $\rho_1$ is determined and the density $\rho_c$ of the cured epoxy is determined as follows:

$$\rho_c = (A/P)\rho_1 \qquad \text{Eq. 2}$$

The volumetric shrinkage Vs of the uncured and cured epoxies is determined by determining the volumes of the uncured and cured epoxy using the density values $\rho_u$ and $\rho_c$ obtained above. The volume of the uncured epoxy $V_u$ is determined by measuring the weight W of a specimen of the uncured epoxy and determining its volume as follows:

$$V_u = W_u/\rho_u \qquad \text{Eq. 3}$$

The epoxy is then cured in accordance with the cure schedule presented below and the weight $W_c$ of the now-cured specimen is determined. The volume of the cured epoxy $V_c$ is determined as follows:

$$V_C = W_C/\rho_C \qquad \text{Eq. 4}$$

The volumetric shrinkage Vs in per cent is then determined as follows:

$$V_s = [(V_u - V_C)/V_u](100) \qquad \text{Eq. 5}$$

EXAMPLE I

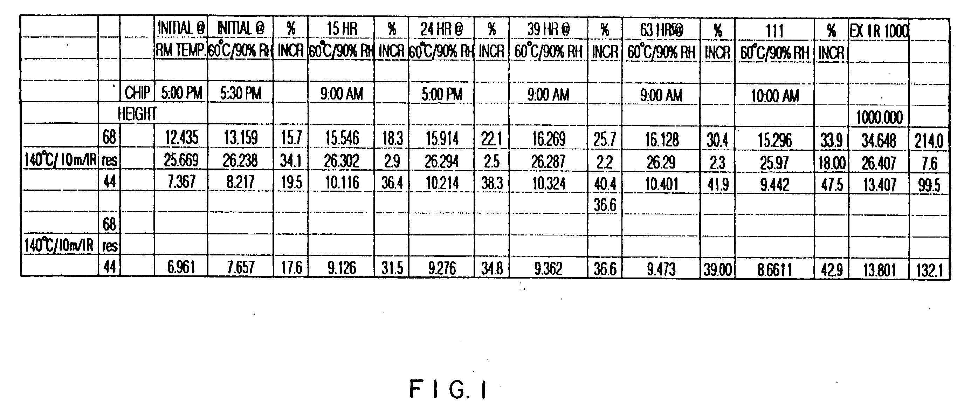

As a representative example of the change in junction resistance under 90% relative humidity conditions, a conductive cement manufactured by Emerson & Cuming of Lexington, MA and sold under the AMICON™ CSM-933-65-1 designation, was used to connect a 68-pin surface-mount device (SMD), two 44-pin surface-mount devices, and a ten resistor series string in a test circuit and subjected to a 140°C cure for a period of 10 minutes consistent with the manufacturer's instructions. The pins of the various surface-mount devices were series-connected through resistive elements within the surface-mount devices and the total junction resistance determined by subtracting the cumulative series resistance of the intra-device components from the total measured resistance. In a similar manner, the resistance measurement for the resistor-string was effected by subtracting the cumulative values of the resistors that comprised the string from the total series resistance to arrive at a cumulative junction resistance value. The resistance of the intra-device elements of the surface-mount devices as well as the resistors within the resistor string was stable within the temperature and humidity range of the tests as verified by control circuits. The initial junction resistance in ohms was measured at room temperature and at test conditions of 60° C and 90% relative humidity as shown in FIG. 1. The resistance was then again measured after 15.5, 24, 39 and 63 hours exposure at the 60°C and 90% relative humidity test conditions. As shown in Fig. 1, the ohmic resistance of all junctions increased with time at 90% relative humidity with an extrapolated value for 1000-hours indicating a substantial increase for the 68-pin devices and the two 44-pin devices and less of an increase for the resistor-string.

As can be appreciated from a consideration of the data in FIG. 1, a known conductive cement junction undergoes a substantial increase in resistance over time at elevated relative humidity.

EXAMPLE II

A conductive cement is prepared using a conductive filler including three types of silver particulate A, B, and C. Particulate A is a silver flake having a Fisher Sub-Sieve Size (FSSS) in the range of 0.90-1.30 micrometer, a tap density (by Tap-Pak Volumeter) of 3.0 to 3.5 g/cc, a Scott apparent density of 30-35 g/in$^3$, a surface area of 0.3-0.6m$^2$/g and a size distribution of 90% < 14.00 micrometer, 50% < 7.00 micrometer, and 10% < 2.00 micrometer. The size distribution data presented herein were determined with a Leeds and Northrop Microtrac. A suitable particulate A is "Silver Flake #53" available from the Electronic Materials Division of the Metz Metallurgical Corporation, South Plainfield, NJ.

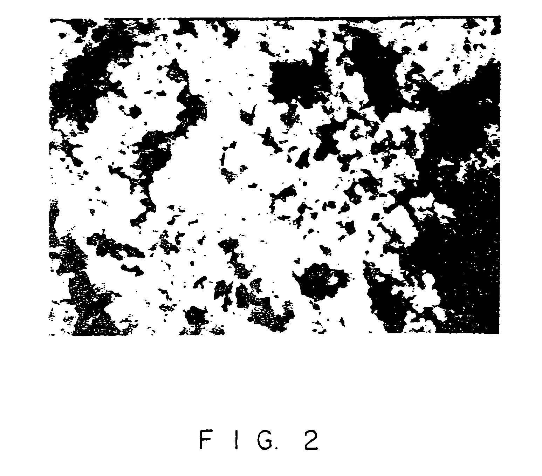

Particulate B is silver agglomerate having a Fisher sub-sieve size (FSSS) of 0.6 micrometers, a tap density (by Tap-Pak Volumeter) of 1.85 g/cc, a Scott apparent density of 16.7 g/in$^3$, a surface area of 1.62m$^2$/g and a size distribution of 100% < 10.6 micrometers, 90% < 8.10 micrometers, 50% < 4.4 micrometers, and 10% < 1.40 micrometers with a mean size of 4.5 micrometers. A suitable particulate B is "Silver Powder SPS-100" available from Metz Metallurgical Corporation. This silver agglomerate as shown in the photomicrograph of FIG. 2, has many rough surface features.

Particulate C is silver powder having a Fisher Sub-Sieve Size (FSSS) of 0.70 microns, a tap density (by Tap-Pak Volumeter) of 2.75 g/cc, a Scott apparent density of 17.5 g/in$^3$, and a surface area of 1.84m$^2$/g and a size distribution of 100% < 5.27 micrometer, 90% < 3.16 micrometer, 50% < 1.25 micrometer, and 10% < 0.51 micrometer. A suitable particulate C is "Fine Silver Powder S-ED" available from Metz Metallurgical Corporation.

Particulates A, B, and C are mixed in a weight ratio of about 40%, 30%, and 30% to constitute the metallic silver filler that is admixed with the carrier.

The carrier comprises a polymer mixture of two epoxy resins, Epoxy A and Epoxy B. Epoxy A is a bisphenol F epoxy resin such as "Aratronic 5046", a bisphenol F diglycidyl ether, having a relatively low viscosity of 1400 cps at 25°C, available from the Ciba-Geigy Corporation. Epoxy B is a liquid phenol epoxy novolac resin, such as "Quatrex 2010", a phenol epoxy novolac resin having a relatively high viscosity of 25,000-45,000 cps at 52°C, available from Dow Chemical Corporation, Midland, MI.

The polymeric carrier may also include a conventional hardener such as an imidazole, for instance, N-(2-cyanoethyl)-2-ethyl,4-methylimidazole, available from PolyOrganix Corporation of Newburyport, MA under the CURIMID™-CN designation.

The polymeric carrier can also include a coupling or wetting agent to provide enhanced wetting of the uncured material. A representative coupling agent is gamma-glycidoxypropyltrimethoxysilane, available from the Union Carbide Company under the "A-187" designation. Yet another adjuvant includable in the polymeric carrier of the present invention is gamma-butyrolactone, available from the Aldrich Chemical Co., Milwaukee, WI, which material functions as a diluent to adjust viscosity.

A conductive cement composition having the following formulation was prepared:

| Component | Batch Quantity - % weight |
|---|---|
| | (normalized weight units) |
| Epoxy A | 8.275 |
| Epoxy B | 8.275 |
| Hardener | 3.973 |
| Diluent | 1.985 |
| Coupling Agt | 0.993 |
| | total epoxy wt = 23.5% |
| Particle A | 30.600 |
| Particle B | 22.950 |
| Particle C | 22.950 |
| | total silver wt = 76.5% |

The 76.5% silver content represents a preferred value for common application techniques such as application by stencil, screen print, tampo print, syringe, etc. Below 74% this conductive cement composition can exhibit electrical instability with resistance increasing by an order of magnitude under various test conditions. Above 78% this conductive cement composition is too viscous for use in stencil and screen printing applications, although still suitable for application by syringe.

The above polymeric carrier was determined to have a volumetric shrinkage 17%. In a first experiment, electrical leads were initially cleaned with acetone and the above formulation used to connect a 68-pin surface-mount device (SMD), a 44-pin surface-mount device, and a series-connected resistor string in each of six test circuits (Trials 1-6) as described in Example I.

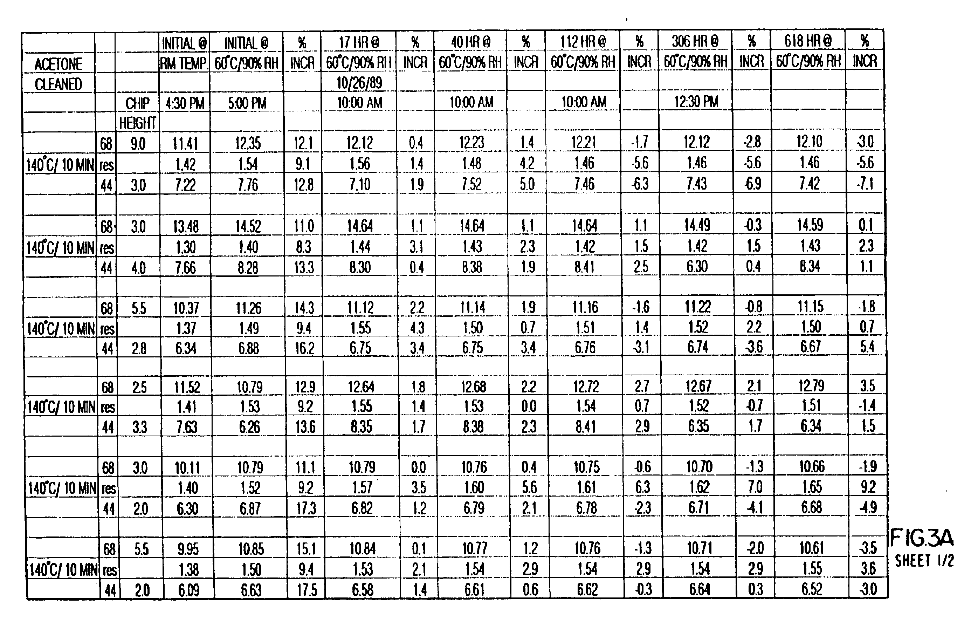

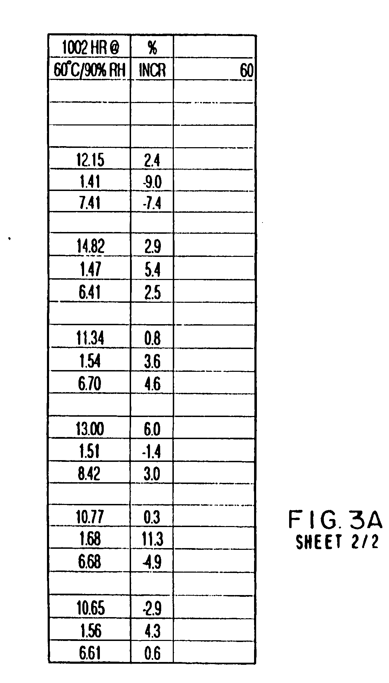

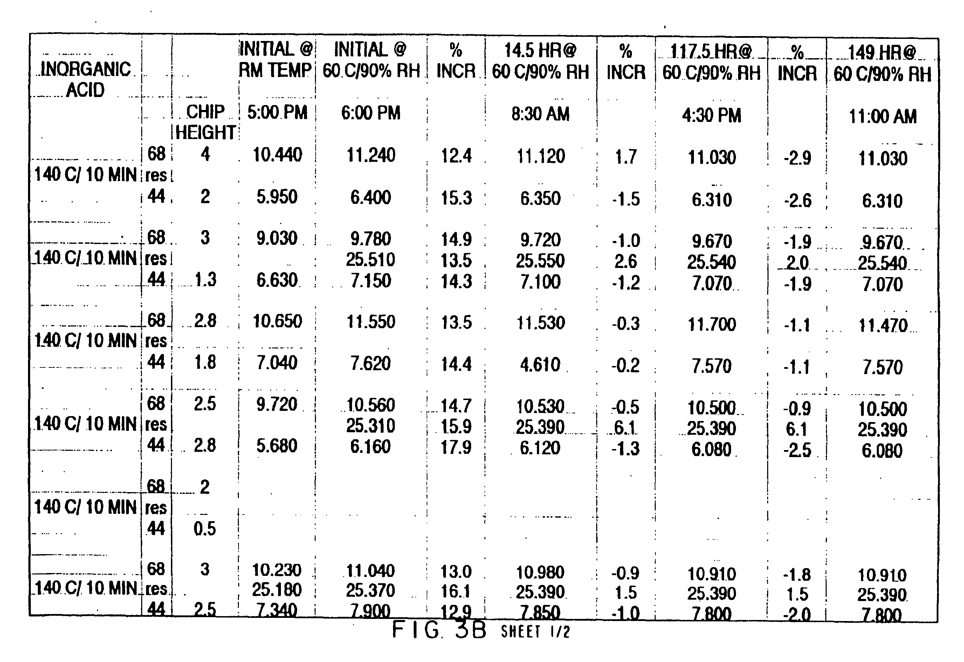

The junction resistance was measured at room temperature and at test conditions of 60°C and 90% relative humidity as shown in FIG. 3A. The resistivity was then again measured after 17, 40, 112, 306, 618, and 1002 hours exposure at the 60°C and 90% relative humidity test conditions. As shown by the % increment columns in FIG. 3A, the ohmic resistance of all junctions varied minimally after 1002 hours at 90% relative humidity with only one set of junctions having an increase in resistance over 11%.

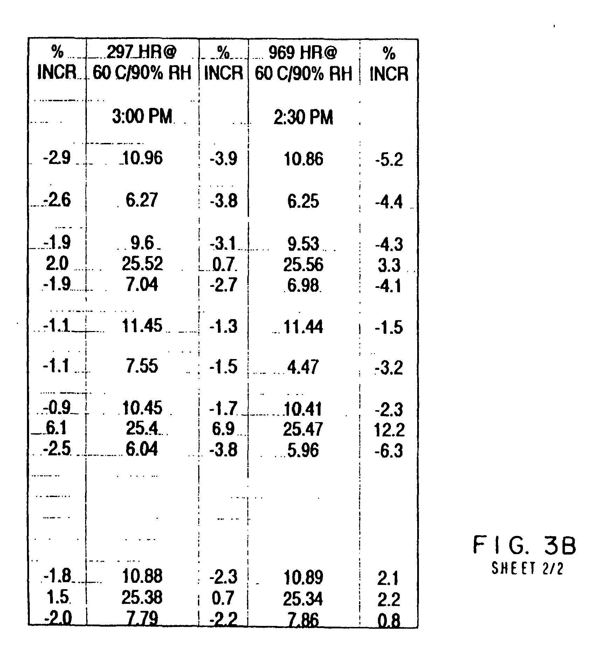

In a second experiment, the electrical leads of the above-described devices were first cleaned with an inorganic acid and the connections made with the formulation of this Example in the manner described above. The junction resistance was measured at room temperature and at test conditions of 60°C and 90% relative humidity as shown in FIG. 3B. The resistivity was then measured after 14.5, 117.5, 149, 297, and 969 hours exposure at the 60°C and 90% relative humidity test conditions. As shown by the % increment columns in FIG. 3B, the ohmic resistance of all junctions varied minimally after 969 hours at 90% relative humidity with only one set of junctions having an increase in resistance over 12%.

EXAMPLE III

A conductive cement is prepared using a conductive particle filler of three types of silver particulates A,B, and C. Particulates A, B, and C are those described above in Example II and are similarly mixed in a weight ratio of 40%, 30%, and 30% to constitute a filler that is admixed with a carrier.

The carrier comprises a single epoxy resin. The epoxy is a liquid bisphenol A epoxy resin such as "Quantrex 1010", having a viscosity of 11,000-14,000 cps at 25°C, available from the Dow Chemical Corporation.

The polymeric carrier can also include a hardener (N-(2-cyanoethyl)-2-ethyl,4-methylimidazole), gamma-glycidoxypropyltrimethoxysilane and a diluent gamma-butyrolactone.

A conductive cement was prepared with the following formulation:

| Component | Batch Quantity - % weight |
|---|---|
| | (normalized weight units) |
| Epoxy | 16.55 |
| Hardener | 3.97 |
| Coupling Agent | 0.99 |
| Diluent | 1.99 |
| | total epoxy wt = 23.50% |
| Particle A | 30.600 |
| Particle B | 22.950 |
| Particle C | 22.950 |
| | total silver wt = 76.5% |

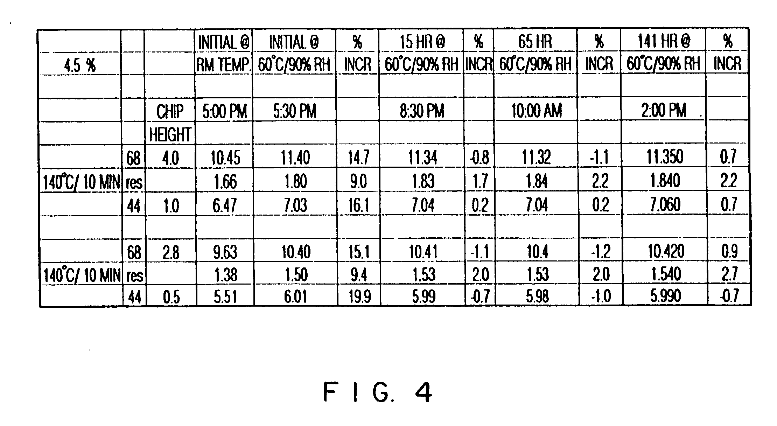

The above polymeric carrier was determined to have a volumetric shrinkage of 13% and was used to connect a 68-pin surface-mount device (SMD), a 44-pin surface-mount device, and a series-connected resistor string in each of two test circuits (Trials 1-2) as described in Example I. The junction resistance was measured at room temperature and at test conditions of 60°C and 90% relative humidity as shown in FIG. 4. The resistivity was then again measured after 15, 65, and 141 hours exposure at the 60°C and 90% relative humidity test conditions. As shown by the % increment columns in FIG. 4, the ohmic resistance of all junctions varied minimally after 141 hours at 90% relative humidity with two (2) sets of junctions having an increase in resistance over 2%.

EXAMPLE IV

A conductive cement is prepared using a conductive particle filler of two types of silver particulates A and C which are identical to particulates A and C described above for Example II.

Particulates A and C are desirably mixed in a weight ratio of 40% and 60% to constitute the filler that is admixed with the carrier.

The carrier comprises a mixture of two epoxy resins, Epoxy A and Epoxy B. Epoxy A is a bisphenol F epoxy resin such as "Aratronic 5046". Epoxy B is a liquid phenol epoxy novolac resin, such as "Quatrex 2010".

The polymeric carrier can also include a hardener (N-(2-cyanoethyl)-2-ethyl,4-methylimidazole) a coupling agent (gamma-glycidoxypropyltrimethoxysilane) and a diluent (gamma-butyrolactone).

A conductive cement was prepared with the following formulation:

| Component | Batch Quantity - % weight |
|---|---|
| | (normalized weight units) |
| Epoxy A | 8.21 |
| Epoxy B | 8.21 |
| Hardener | 3.94 |
| Diluent | 0.66 |
| Coupling Agent | 0.99 |
| | total epoxy wt = 22.0% |
| Particle A | 31.20 |
| Particle C | 46.80 |
| | total silver wt = 78.0% |

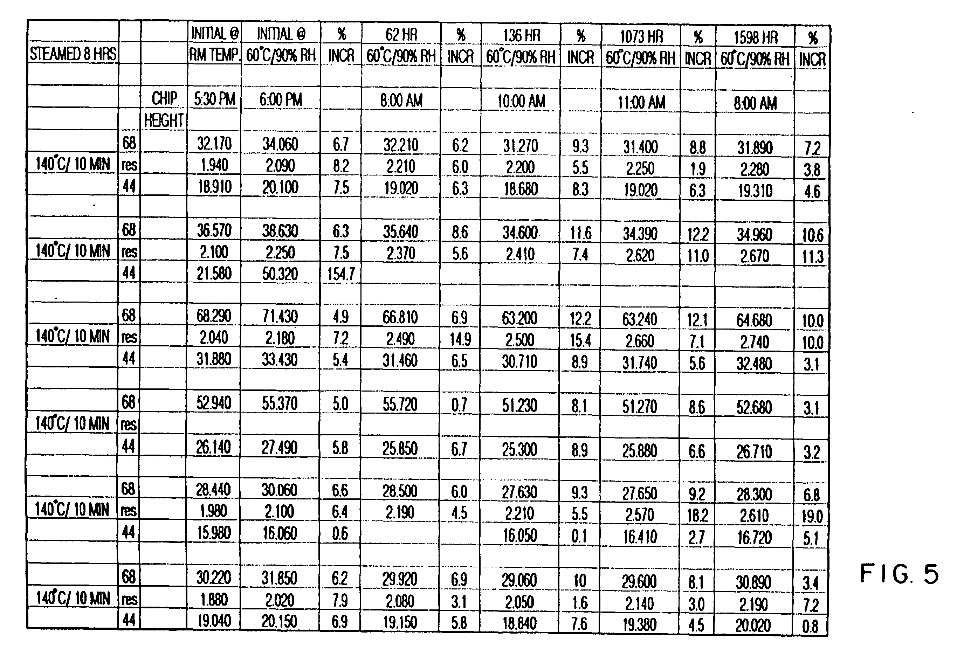

The above polymeric carrier was determined to have a volumetric shrinkage of 10% and was used to connect a 68-pin surface-mount device (SMD), a 44-pin surface-mount device, and a series-connected resistor string in each of six test circuits (Trials 1-6) as described in Example I. The junction resistance was measured at room temperature and at test conditions of 60°C and 90% relative humidity as shown in FIG. 5. The resistivity was then again measured after 62, 136, 1073, and 1598 hours exposure at the 60°C and 90% relative humidity test conditions. As shown by the % increment columns in FIG. 5, the ohmic resistance of all junctions varied minimally after 1598 hours at 90% relative humidity with only one set of junctions having an increase in resistance over 19%.

EXAMPLE V

A conductive cement is prepared using a conductive filler of three types of silver particulates A, B, and C which are identical to particulates A, B, and C described above for Example II. Particulates A, B, and C are desirably mixed in a weight ratio of 40%, 30%, and 30% to constitute the filler that is mixed with a carrier. The carrier comprises a single epoxy/solvent combination. The epoxy is a bisphenol A epoxy resin such as 'EPONOL (R) 53-BH-35', a high molecular weight epoxy available from the Shell Chemical Company, Houston, TX. In the form provided by the manufacturer, the epoxy resin represents about 35% of the as-supplied material with the remainder comprising a solvent of about 75% methyl ethyl ketone (MEK) and 25% propylene glycol methylether (PGME). Prior to use in formulating the conductive cement of Example V, the MEK and PGME are removed and replaced with 2-butoxyethyl acetate available, for example, from the Aldrich Chemical Co.

A conductive cement composition in accordance with the present invention was prepared and has the following formulation:

| Component | Batch Quantity - % weight |
|---|---|
| | (normalized weight units) |
| Epoxy | 12.921 |
| Solvent | 23.996 |
| | total epoxy wt = 36.917% |
| Particle A | 25.233 |
| Particle B | 18.925 |
| Particle C | 18.925 |
| | total silver wt = 63.083% |

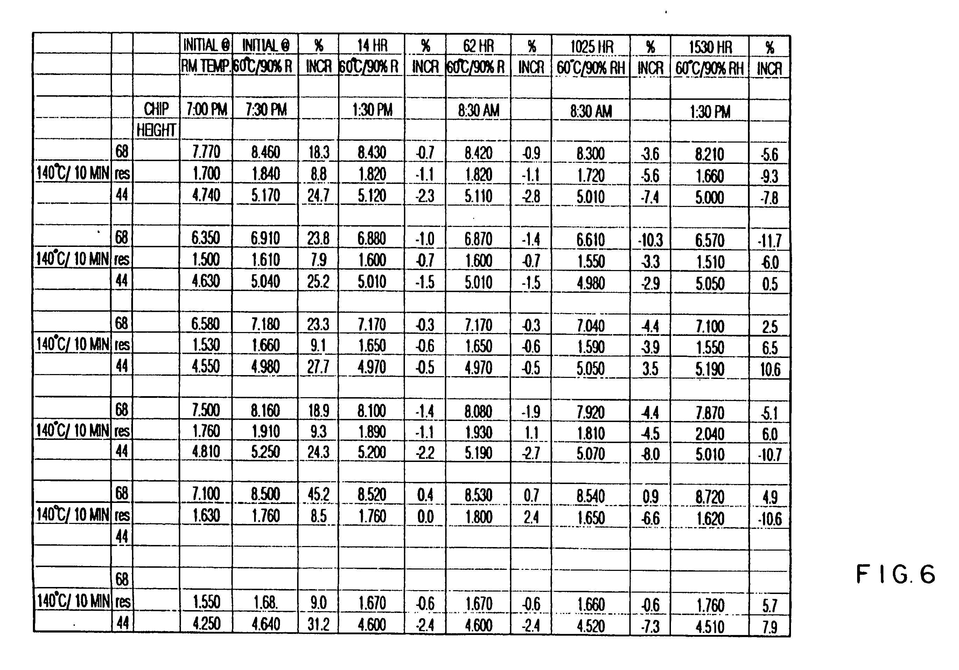

The above polymeric carrier was determined to have a volumetric shrinkage of 65% and was used to connect a 68-pin surface-mount device (SMD), a 44-pin surface-mount device, and a series-connected resistor string in each of six test circuits (Trials 1-6) as descried in Example I. The junction resistance was measured at room temperature and at test conditions of 60°C and 90% relative humidity as shown in FIG. 6. The resistivity was then measured after 6, 13, 349, and 1530 hours exposure at the 60°C and 90% relative humidity test conditions. As shown by the % increment columns in FIG. 6, the ohmic resistance of all junctions varied minimally after 1530 hours at 90% relative humidity with only one set of junctions having an increase in resistance over 10%.

EXAMPLE VI

A conductive cement is prepared using a conductive particle filler of three types of silver particulates A, B, and C which are identical to particulates A, B, and C described above for Example II. Particulates A, B, and C are desirably mixed in a weight ratio of 40%, 30%, and 30% to constitute a filler that is mixed with a carrier.

The carrier comprises a single epoxy/solvent combination. The epoxy is a novolac epoxy resin such as "Quatrex 2010", a phenol epoxy novolac resin having a relatively high viscosity of 25,000-45,000 cps at 52°C available from Dow Chemical Corporation. The solvent 2-(2-ethoxyethoxy) ethyl acetate is available under the tradename "Carbitol" acetate from the Eastman Kodak Co., Rochester, NY and is also known as diethylene glycol monoethyl ether acetate. The polymeric carrier can also include a hardener (N-(2-cyanoethyl)-2-ethyl,4-methylimidazole) and a coupling agent (gamma-glycidoxypropyltrimethoxysilane).

A conductive cement was prepared with the following formulation:

| Component | Batch Quantity - % weight |
|---|---|
| | (normalized weight units) |
| Epoxy | 14.79 |
| Solvent | 6.34 |
| Hardener | 1.18 |
| Coupling Agent | 0.89 |
| | total epoxy wt = 23.20% |
| Particle A | 30.72 |
| Particle B | 23.04 |
| Particle C | 23.04 |

(continued)

| Component | Batch Quantity - % weight |
|---|---|
| | (normalized weight units) |
| | total silver wt = 76.80% |

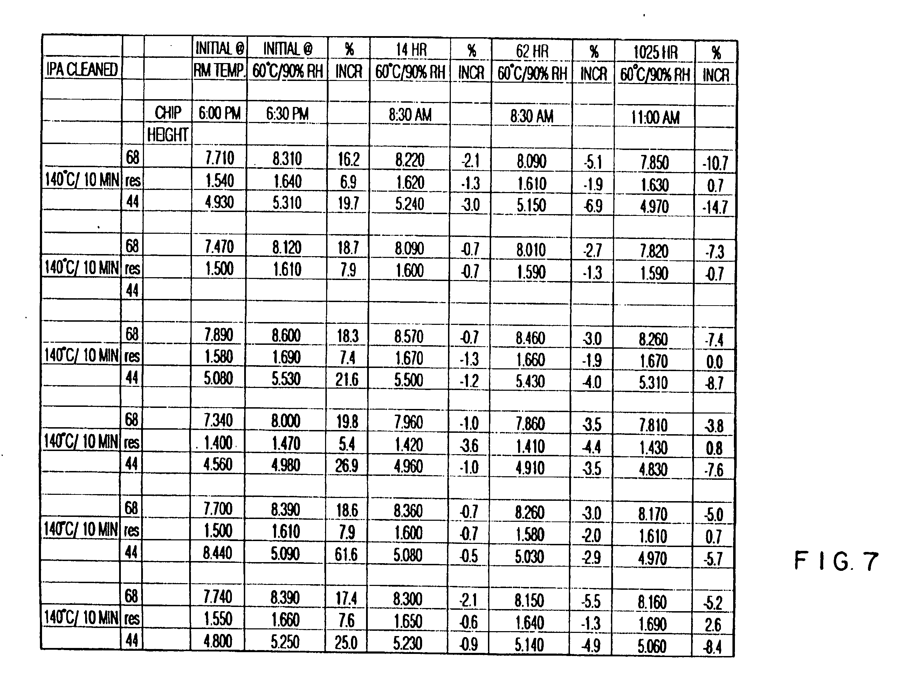

The above polymeric carrier was determined to have a volumetric shrinkage of 25% and was used to connect a 68-pin surface-mount device (SMD), a 44-pin surface-mount device, and a series-connected resistor string in each of six test circuits (Trials 1-6) as described in Example I. The junction resistance was measured at room temperature and at test conditions of 60°C and 90% relative humidity as shown in FIG. 7. The resistivity was then again measured after 14, 62, and 1025 hours exposure at 60°C and 90% relative humidity test conditions. As shown by the % increment columns in FIG. 7, the ohmic resistance of all junctions varied minimally after 1025 hours at 90% relative humidity.

EXAMPLE VII

A conductive cement is prepared using a conductive particle filler of three types of silver particulates A, B, and C which are identical to particulates A, B, and C described above for Example II. Particulates A, B, and C are desirably mixed in a weight ratio of 40%, 30%, and 30% to constitute the metallic silver filler that is admixed with a carrier.

The carrier comprises a mixture of two epoxy resins, Epoxy A and Epoxy B. Epoxy A is a bisphenol A epoxy resin such as "Eponol 53" described above and Epoxy B is a liquid phenol Epoxy novolac resin, such as "Quatrex 1010", also described above.

The polymeric carrier can also include hardeners I and II. Hardener I is a polyoxypropylenediamine available under the Jeffamine D-230 designation from the Texaco Chemical Company, and hardener II is a triethyleneglycoldiamine available under the Jeffamine EDR 148 designation, also from the Texaco Chemical Company.

The polymeric carrier may include an accelerator to promote curing. A suitable accelerator such as a mixture of aliphatic amines is available from the Texaco Chemical Company under the ’399’ designation. The polymeric carrier may also include an adhesion promoter such as a glyceryl poly(oxypropylene) triamine available under the Jeffamine T-5000 designation from the Texaco Chemical Company.

A conductive cement composition was prepared with the following formulation:

| Component | Batch Quantity - % weight |
|---|---|
| | (normalized weight units) |
| Epoxy A | 13.50 |
| Epoxy B | 8.94 |
| Hardener I | 2.59 |
| Hardener II | 0.36 |
| Accelerator | 0.27 |
| Adhesion Promoter | 1.34 |
| | total epoxy wt = 27.00% |
| Particle A | 29.20 |
| Particle B | 21.90 |
| Particle C | 21.90 |
| | total silver wt = 73.00% |

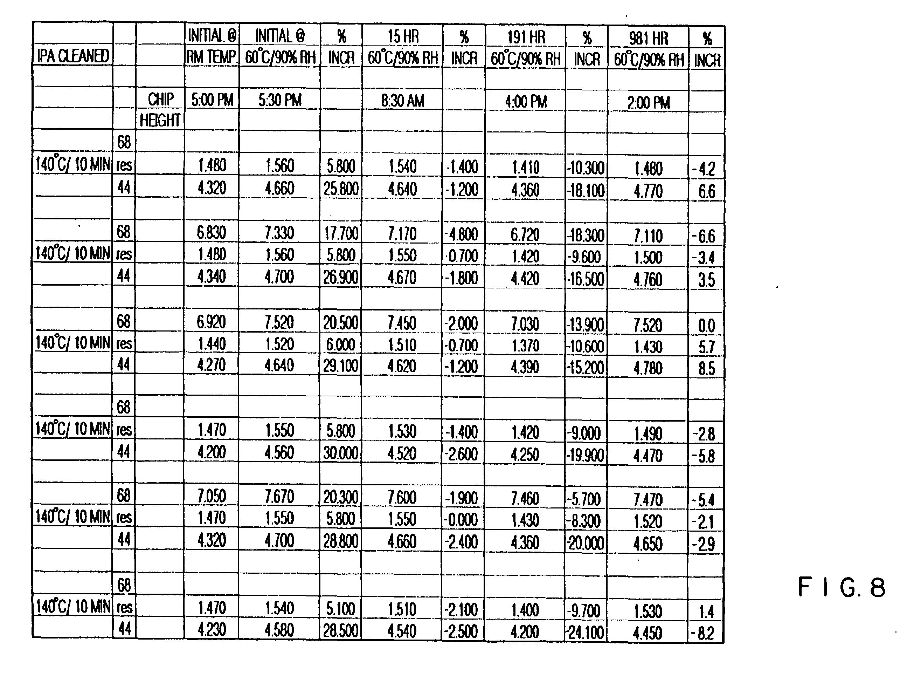

The above polymeric carrier was determined to have a volumetric shrinkage of 19% and was used to connect a 68-pin surface-mount device (SMD), a 44-pin surface-mount device, and a series-connected resistor string in each of six test circuits (Trials 1-6) as described in Example I. The junction resistance was measured at room temperature and at test conditions of 60°C and 90% relative humidity as shown in FIG. 8. The resistivity was then again measured after 15, 191, and 981 hours exposure at the 60°C and 90% relative humidity test conditions. As shown by the % increment columns in FIG. 8, the ohmic resistance of all junctions varied minimally after 1598 hours at 90% relative humidity with only one set of junctions having an increase in resistance over 8%.

EXAMPLE VIII

A conductive cement is prepared using a conductive particle filler of two types of conductive particles, particulates A and D. Particulate A is identical to particulate A described above for Example I. Particulate D comprises silver-coated nickel particles having a mean particle dimension of 28u with an actual size distribution of 90% < 48.19 micrometers, 50% < 27.97 micrometers, and 10% < 12.36 micrometers. A suitable particulate D is available from Novamet Specialty Products Corp., an INCO Company, 681 Lawlins Road, Wyckof, N.J. 07481 (201-891-7976).

Particulates A and D are desirably mixed in a weight ratio of 80% and 20% to constitute a filler that is admixed with a carrier.

The carrier comprises a mixture of two epoxy resins, Epoxy A and Epoxy B. Epoxy A is a bisphenol F epoxy resin such as "Aratronic 5046" and Epoxy B is a liquid phenol epoxy novolac resin, such as "Quatrex 2010".

The polymeric carrier can also include a hardener (N-(2-cyanoethyl)-2-ethyl,4-methylimidazole) and a coupling agent (gamma-glycidoxypropyltrimethoxysilane).

A conductive cement composition was prepared with the following formulation:

| Component | Batch Quantity - % weight |
|---|---|
| | (normalized weight units) |
| Epoxy A | 7.50 |
| Epoxy B | 7.50 |
| Hardener | 3.60 |
| Coupling Agent | 0.90 |
| | total epoxy wt = 19.5% |
| Particle A | 64.40 |
| Particle D | 16.10 |
| | total silver wt = 80.5% |

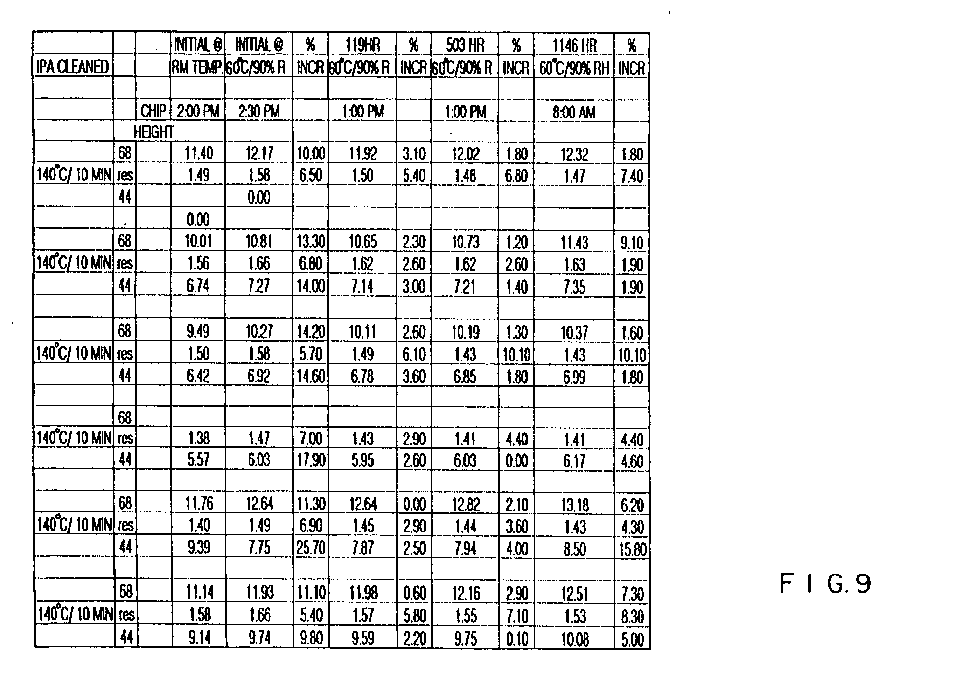

The above polymeric carrier formulation was determined to have a volumetric shrinkage of 7.6% and was used to connect a 68-pin surface-mount device (SMD), a 44-pin surface-mount device, and a series-connected resistor string in each of six test circuits (Trials 1-6) as described in Example I. The junction resistance was measured at room temperature and at test conditions of 60°C and 90% relative humidity as shown in FIG. 9. The resistivity was then again measured after 119, 503, and 1146 hours exposure at the 60°C and 90% relative humidity test conditions. As shown by the % increment columns in FIG. 9, the ohmic resistance of all junctions varied minimally after 1146 hours at 90% relative humidity with only one set of junctions having an increase in resistance over 15%.

EXAMPLE IX

A conductive cement is prepared using a conductive particle filler of two types of conductive particles, particulates A and E, of which particulate A is identical to particulate A described above for Example I. Particulates E are silver-coated nickel particles of about 32 % wt. silver having a Scott apparent density of 3.66 g/in$^3$, a surface area of 0.22m$^2$/g, a powder resistivity of 0.4 m ohm.cm, and a mean particle dimension of 21u with an actual size distribution of 90 % < 29.3 micrometer, 50% < 19.5 micrometer, and 10% < 13.9 micrometer. A suitable particulate E is available from Potter Industries, Inc., Carlstadt, NJ under the Conducto-0-Fil Silver Nickel designation.

Particulates A and E are desirably mixed in a weight ratio of 80% and 20% to constitute a filler that is admixed with a carrier.

The carrier comprises principally a mixture of two epoxy resins, Epoxy A and Epoxy B. Epoxy A is a bisphenol F epoxy resin such as "Aratronic 5046" and Epoxy B is a liquid phenol epoxy novolac resin, such as "Quatrex 2010".

The polymeric carrier can also include a hardener (N-(2-cyanoethyl)-2-ethyl,4-methylimidazole) and a coupling agent (gamma-glycidoxypropyltrimethoxysilane).

A conductive cement was prepared with the following formulation:

| Component | Batch Quantity - % weight |
|---|---|
| | (normalized weight units) |
| Epoxy A | 7.50 |
| Epoxy B | 7.50 |
| Hardener | 3.60 |
| Coupling Agent | 0.90 |
| | total epoxy wt = 19.5% |
| Particle A | 64.40 |

(continued)

| Component | Batch Quantity - % weight |
|---|---|
| | (normalized weight units) |
| Particle E | 16.10 |
| | total silver wt = 80.5% |

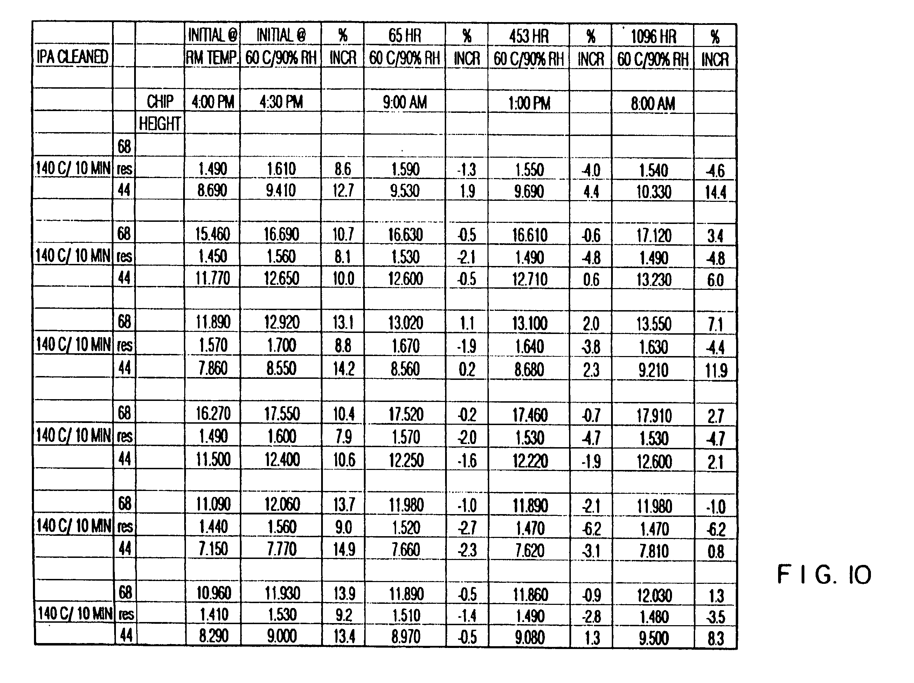

The above polymeric carrier was determined to have a volumetric shrinkage characteristic of 7.6% and was used to connect a 68-pin surface-mount device (SMD), a 44-pin surface-mount device, and a series-connected resistor string in each of six test circuits (Trials 1-6) as described in Example I. The junction resistance was measured at room temperature and at test conditions of 60°C and 90% relative humidity as shown in FIG. 10. The resistivity was then again measured after 65, 453, 1096 hours exposure at the 60°C and 90% relative humidity test conditions. As shown by the % increment columns in FIG. 10, the ohmic resistance of all junctions varied minimally after 1096 hours at 90% relative humidity with only one set of junctions having an increase in resistance over 14%.

EXAMPLE X

A conductive cement is prepared using a conductive particle filler of two types of conductive particles, particulates A and F, of which particulate A is identical to particulate A described above for Example I. Particulates F are silver-coated glass spheres of about 23.8% silver having a Scott apparent density of 0.81 g/in$^3$, a powder resistivity of 2.63 milli-ohm cm, and a mean particle dimension of 13 micrometer with an actual size distribution of 90 % < 20.0 micrometer, 50% < 12.1 micrometer, and 10% < 7.1 micrometer. A suitable particulate F is available from Potter Industries, Inc., Carlstadt, NJ 07072 under the Conducto-0-Fil. Silvered Glass Spheres designation. Particulates A and F are desirably mixed in a weight ratio of 92% and 8% to constitute a filler that is admixed with a carrier.

The carrier comprises principally a mixture of two epoxy resins, Epoxy A and Epoxy B. Epoxy A is a bisphenol F epoxy resin such as "Aratronic 5046" and Epoxy B is a liquid phenol epoxy novolac resin, such as "Quatrex 2010".

The polymeric carrier can also include a conventional hardener (N-(2-cyanoethyl)-2-ethyl,4-methylimidazole) and a coupling agent (gamma-glycidoxypropyltrimethoxysilane).

A conductive cement was prepared with the following formulation:

| Component | Batch Quantity - % weight |
|---|---|
| | (normalized weight units) |
| Epoxy A | 7.88 |
| Epoxy B | 7.88 |
| Hardener | 3.78 |
| Coupling Agent | 0.96 |
| | total epoxy wt = 20.5% |
| Particle A | 73.14 |
| Particle F | 6.36 |
| | total silver wt = 79.5% |

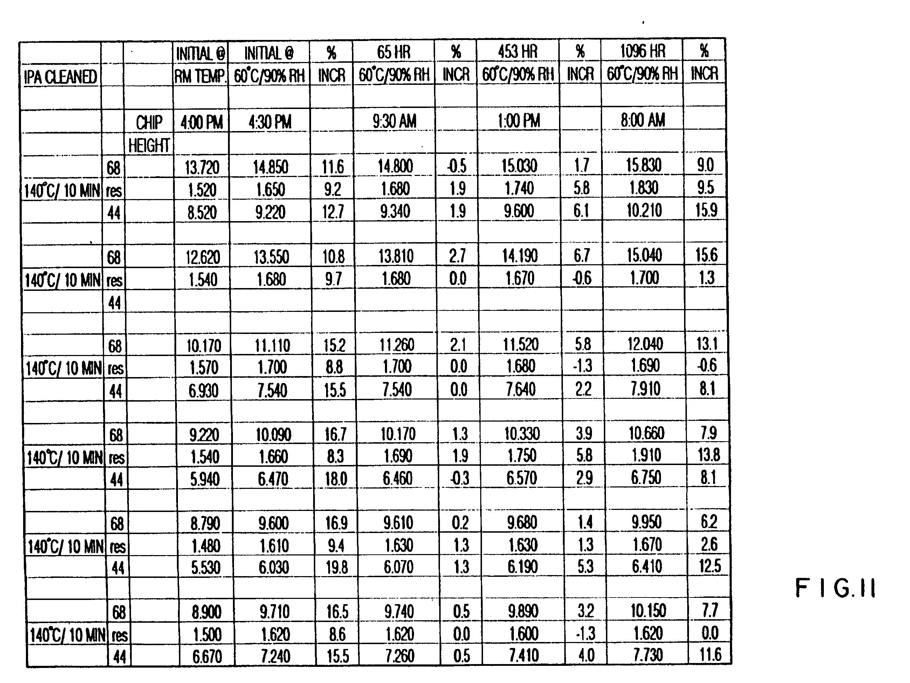

The above polymeric carrier was determined to have a volumetric shrinkage characteristic of 7.6% and was used to connect a 68-pin surface-mount device (SMD), a 44-pin surface-mount device, and a series-connected resistor string in each of six test circuits (Trials 1-6) as described in Example I. The junction resistance was measured at room temperature and at test conditions of 60°C and 90% relative humidity as shown in FIG. 11. The resistivity was then again measured after 65, 453, and 1096 hours exposure at the 60°C and 90% relative humidity test conditions. As shown by the % increment columns in FIG. 11, the ohmic resistance of all junctions varied minimally after 1096 hours at 90% relative humidity with only two (2) sets of junctions having an increase in resistance over 15%.

In some of the test runs of Examples II to X, (results not presented), the high humidity caused pooling of hot liquid water and through-corrosion of the electrical leads outside the cemented junction, resulting in invalid test results.

EXAMPLE XI

A conductive cement is prepared using a conductive particle filler including two types of silver particulates A and B. Particulates A and B are those described above in Example II and are similarly mixed in a weight ratio of 40% (A) to 60% (B) to constitute a filler that is admixed with a carrier.

The carrier comprises a mixture of epoxy resins modified with a synthetic rubber. The modified epoxy mixture includes equal parts by weight of Bisphenol F epoxy resin such as "Aratronic 5046" a Bisphenol F diglycidyl ether, having a viscosity of about 1400 cps at 25°C available from the Ciba-Geigy Corporation; a liquid phenol epoxy novolac resin such as "Quatrex 2010", having a viscosity of about 25,000-45,000 cps at 52°C available from Dow Chemical Corporation; and a butadiene acrylonitrile synthetic rubber modifier such as "Heloxy WC-8005" having a viscosity of about 500,000-1,000,000 cps at 25°C available from Wilmington Chemical Corporation, Delaware, U.S.A.

The polymeric carrier can also include an imidazole type hardener such as "Curimid-CN", N -(2-cyanoethyl) -2-ethyl -4- methylimidazole; a diluent such as gamma-butrolactone; and a coupling agent such as "A-187", gamma-glicidoxypropyltrimethoxysilane.

A conductive cement was prepared with the following formulation:

| Component | Batch Quantity |
|---|---|
| | (wet weight) |
| Bisphenol F | 5.05 |
| Novolac epoxy | 5.05 |
| Butadiene rubber | 5.32 |
| Hardener | 3.19 |
| Diluent | 1.59 |
| Coupling Agent | 0.80 |
| | Total carrier wt.= 21.0 |
| Particulate A | 31.60 |
| Particulate B | 47.40 |
| | Total filler wt.= 79.0 |

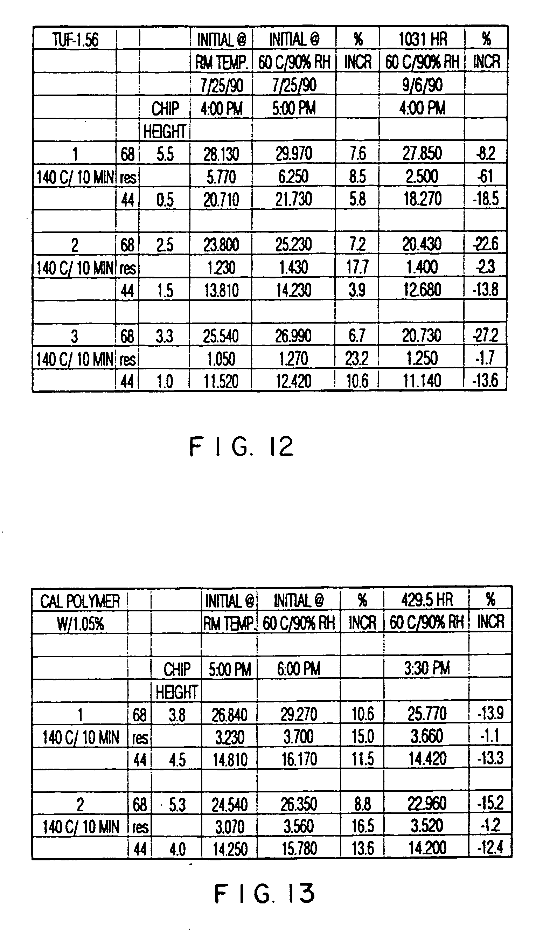

The above polymeric carrier was determined to have a volumetric shrinkage of 10%, a bending diameter of 0.50 inch (determined by bending a strip approximately 4.5 mil thick around the smallest diameter rod possible without damage or cracking of the strip) and was used to connect a 68-pin surface-mount device (SMD), a 44-pin surface-mount device and a series connected resistor string in each of three test circuits (trials 1-3) as described in Example I. The junction resistance is measured at room temperature and at test conditions of 60°C and 90% relative humidity as shown in FIG. 12. The resistivity was again measured after 1031 hours exposure to 60°C at 90% relative humidity test conditions. As shown by the % increase column in FIG. 12, the ohmic resistance of all junctions varied minimally or decreased after 1031 hours.

EXAMPLE XII

A conductive cement is prepared using a conductive particle filler including two types of silver particulates A and B. Particulates A and B are those described above in Example II and are similarly mixed in a weight ratio of 40% (A) to 60% (B) to constitute a filler that is admixed with a carrier.

The carrier comprises a non-filled urethane elastomer, such as "Calthane NF 1300", available from Cal Polymers, Inc., California, U.S.A., which comprises a mixture of about one part aromatic isocyanate (4,4-diphenylmethane diisocyanate and about 20% wt. higher molecular weight polymers) and three parts butadiene homopolymer (hyroxyl terminated polybutadiene).

The polymeric carrier can also include a small amount of solvent such as carbitol acetate (2-(2-ethoxyethoxy) ethyl acetate for adjusting viscosity.

A conductive cement was prepared with the following formulation:

| Component | Batch Quantity |
|---|---|
| | (wet weight) |
| Urethane elastomer | 15.85 |
| Solvent | 1.05 |
| | Total carrier wt.= 16.90 |
| Particulate A | 33.24 |

(continued)

| Component | Batch Quantity |
|---|---|
| | (wet weight) |
| Particulate B | 49.86 |
| | Total filler wt.= 83.10 |

The above polymeric carrier was determined to have a volumetric shrinkage of 7.7%, a bending diameter of 0.25 inch (determined by bending a strip approximately 4.5 mil thick around the smallest diameter rod possible without damage or cracking of the strip) and was used to connect a 68-pin surface-mount device (SMD), a 44-pin surface-mount device and a series connected resistor string in each of two test circuits (trials 1-2) as described in Example I. The junction resistance was measured at room temperature and at test conditions of 60°C and 90% relative humidity as shown in FIG. 13. The resistivity was again measured after 429.5 hours exposure to 60°C at 90% relative humidity test conditions. As shown by the % increase column in FIG. 13, the ohmic resistance of all junctions varied minimally or decreased after 429.5 hours.

EXAMPLE XIII

A conductive cement is prepared using a conductive particle filler including two types of silver particulates A and B. Particulates A and B are those described above in Example II and are similarly mixed in weight ratio of 40% (A) to 60% (B) to constitute a filler that is admixed with a carrier.

The carrier comprises a silicone resin, such as "SR 900", silicone conformal coating available from General Electric Company, Silicone Products Division, New York, U.S.A., which comprises a 50% solution of silicone resin, having a viscosity of about 500 cps at 25°C, in toluene solvent.

The polymeric carrier can also include a small amount of additional solvent such as "Aromatic 150" which is a heavy aromatic solvent naphtha available from Exxon Chemical Co., Texas, U.S.A.

A conductive cement was prepared with the following formulation:

| Component | Batch Quantity |
|---|---|
| | (wet weight) |
| Silicone resin "SR 900" | 22.50 |
| Solvent "Aromatic 150" | 4.50 |
| | Total carrier wt.= 27.00 |
| Particulate A | 29.20 |
| Particulate B | 43.80 |
| | Total filler wt.= 73.00 |

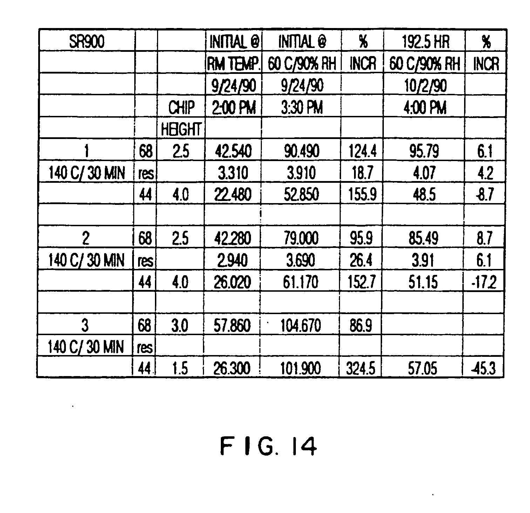

The above polymeric carrier was determined to have a volumetric shrinkage of 25.0%, a bending diameter of 0.25 inch (determined by bending a strip approximately 4.5 mil thick around the smallest diameter rod possible without damage or cracking of the strip) and was used to connect a 68-pin surface-mount device (SMD) and a 44-pin surface-mount device in each of three test circuits (trials 1-3) as described in Example I. Similarly, a series connected resistor string was tested in two circuits (trials 1-2). The junction resistance was measured at room temperature and at test conditions of 60°C and 90% relative humidity as shown in FIG. 14. The resistivity was again measured after 192.5 hours exposure to 60°C at 90% relative humidity test conditions. As shown by the % increase column in FIG. 14, the ohmic resistance of all junctions varied minimally or decreased after 192.5 hours.

The present invention advantageously provides an electrically conductive cement composition having substantially stable conductivity and resistance characteristics under high humidity conditions and is believed to achieve this result as a consequence of providing a cement having a volumetric shrinkage rate in a range that assures particle-to-particle contact and particle-to-connection surface contact to produce a reliable connection.

As will be apparent to those skilled in the art, various changes and modifications may be made to the illustrated electrically conductive cement of the present invention without departing from the spirit and scope of the invention as determined in the appended claims and their legal equivalent.

## Claims

1. An assembly comprising a substrate having a circuit printed thereon and at least one electrical component electrically connected to said circuit with an electrically conductive cement, the electrically conductive cement comprising a polymeric carrier having a volumetric shrinkage characteristic of about 6.8 to about 65%; and
a filler comprising about 60 to about 90% by weight of the cement including conductive particles consisting of:

    i) agglomerate particles having a mean particle size of about 2.0-10.6 microns, an aspect ratio of about 1:1:1 and a rough external appearance **characterized by** sufficient recesses and ridge-like boundaries so as to effect enhanced electrical contact between surfaces adhered with the cement,
    ii) a mixture of flake particles having a FSSS of about 0.90 to about 1.30 microns and a surface area of about 0.03 to 0.6 $m^2$/g and a particle size distribution of about 90% <14 microns, 50% <7 microns, and 10% <2 microns, and
    iii) powder particles having a mean particle size of about 1.6 microns.

2. The assembly of claim 1 wherein said carrier has a shrinkage of at least about 6.8%.

3. The assembly of claim 1 wherein said carrier has a shrinkage is about 7.5-65%

4. The assembly of claim 1 wherein said agglomerate particle size is about 4.5 microns

5. The assembly of claim 4 wherein said agglomerate particles have a FSSS of about 0.6 microns

6. The assembly of claim 1 wherein said carrier is comprised of at least two resins with the proportion of the resins adjusted to provide volumetric shrinkage in the desired range.

7. The assembly of claim 6 wherein said carrier comprises a mixture of about one part bisphenol F diglycidyl ether resin and about one part liquid phenol epoxy novolac resin and about one part of a mixture of hardener, diluent and coupling agent.

8. The assembly of claim 1 wherein said filler comprises about 63.1-76.8%

9. The assembly of claim 8 wherein said filler is a mixture of said flake particles, said agglomerate particles and said powder particles in a weight ratio of approximately 40%, 30%, and 30%, respectively.

10. The assembly of claim 9 wherein said powder particles are silver.

11. The assembly of claim 9 wherein said silver particles have a FSSS of about 0.75 microns.

12. The assembly of claim 9 wherein said powder particles have a mean particle size of about 1.6 microns.

13. The assembly of claim 1 wherein said substrate is flexible.

## Patentansprüche

1. Anordnung, die ein Substrat mit einer darauf gedruckten Schaltung und mindestens eine elektrische Komponente, die mit der Schaltung mittels eines elektrisch leitfähigen Zements elektrisch verbunden ist, umfasst, wobei der elektrisch leitfähige Zement einen polymeren Träger mit einer volumetrischen Schrumpfungscharakteristik von etwa 6,8 bis etwa 65 % und einen Füllstoff umfasst, der, bezogen auf das Gewicht, etwa 60 bis etwa 90 % des Zements ausmacht und leitfähige Teilchen einschließt, die aus

    i) Agglomeratteilchen mit einer mittleren Teilchengröße von etwa 2,0 bis 10,6 μm, einem Aspektverhältnis von etwa 1 : 1 : 1 und einem rauen äußeren Erscheinungsbild, das durch ausreichend Einbuchtungen und gratartige Grenzen **gekennzeichnet** ist, um so einen erhöhten elektrischen Kontakt zwischen den mit dem Zement verbundenen Oberflächen zu bewirken,
    ii) einer Mischung aus Flockenteilchen mit einer FSSS von etwa 0,90 bis etwa 1,30 μm und einer Oberfläche von etwa 0,03 bis 0,6 $m^2$/g sowie einer Teilchengrößeverteilung von etwa 90 % < 14 μm, 50 % < 7 μm und 10

% < 2 μm, und
iii) Pulverteilchen mit einer durchschnittlichen Teilchengröße von etwa 1,6 μm

besteht.

2. Anordnung nach Anspruch 1, bei der der Träger eine Schrumpfung von mindestens etwa 6,8 % aufweist.

3. Anordnung nach Anspruch 1, bei der der Träger eine Schrumpfung von etwa 7,5 bis 65 % aufweist.

4. Anordnung nach Anspruch 1, bei der die Agglomeratteilchengröße etwa 4,5 μm beträgt.

5. Anordnung nach Anspruch 4, bei der die Agglomeratteilchen eine FSSS von etwa 0,6 μm aufweisen.

6. Anordnung nach Anspruch 1, bei der der Träger mindestens zwei Harze umfasst, wobei der Anteil der Harze so eingestellt ist, dass eine volumetrische Schrumpfung in dem gewünschten Bereich geliefert wird.

7. Anordnung nach Anspruch 6, bei der der Träger eine Mischung aus etwa einem Teil Bisphenol-F-diglycidylether-Harz und etwa einem Teil flüssigem Phenolepoxinovolak-Harz sowie etwa einem Teil einer Mischung von Härter, Verdünnungsmittel und Kupplungsmittel umfasst.

8. Anordnung nach Anspruch 1, bei der der Füllstoff etwa 63,1 bis 76,8 % ausmacht.

9. Anordnung nach Anspruch 8, bei der der Füllstoff eine Mischung der Flockenteilchen, der Agglomeratteilchen und der Pulverteilchen in einem Gewichtsverhältnis von ungefähr 40 %, 30 % bzw. 30 % ist.

10. Anordnung nach Anspruch 9, bei der die Pulverteilchen Silber sind.

11. Anordnung nach Anspruch 9, bei der die Silberteilchen eine FSSS von etwa 0,75 μm aufweisen.

12. Anordnung nach Anspruch 9, bei der die Pulverteilchen eine mittlere Teilchengröße von etwa 1,6 μm aufweisen.

13. Anordnung nach Anspruch 1, bei der das Substrat flexibel ist.

## Revendications

1. Assemblage comprenant un substrat présentant un circuit imprimé sur son dessus et au moins un constituant électrique électriquement connecté audit circuit avec un ciment électroconducteur, le ciment électroconducteur comprenant un support polymère présentant une caractéristique de retrait volumétrique d'environ 6.8 à environ 65% ; et
une charge comprenant d'environ 60 à environ 90% en poids du ciment incluant des particules conductrices constituées :

   i) de particules d'agglomérats ayant une taille moyenne de particules d'environ 2.0-10.6 microns, un rapport d'allongement d'environ 1 :1 :1 et une apparence externe rugueuse **caractérisées par** suffisamment de creux et de limites en forme de crête afin de réaliser un contact électrique amélioré entre des surfaces collées avec le ciment,
   ii) un mélange de particules de flocons ayant une valeur FFSS d'environ 0.90 à environ 1.30 microns et une surface spécifique d'environ 0.03 à 0.6 $m^2$/g et une distribution de taille de particules d'environ 90%<14 microns, 50%<7 microns, et 10%<2 microns, et
   iii) de particules de poudre ayant une taille moyenne de particules d'environ 1.6 microns.

2. Assemblage selon la revendication 1, dans lequel ledit support présente un retrait d'au moins environ 6,8%.

3. Assemblage selon la revendication 1, dans lequel ledit support présente un retrait d'environ 7,5-65%.

4. Assemblage selon la revendication 1, dans lequel ladite taille de particules d'agglomérats est d'environ 4,5 microns.

**5.** Assemblage selon la revendication 4, dans lequel lesdites particules d'agglomérats présentent une valeur FFSS d'environ 0,6 microns.

**6.** Assemblage selon la revendication 1, dans lequel ledit support est constitué d'au moins deux résines avec la proportion des résines ajustée pour fournir un retrait volumétrique dans l'intervalle souhaité.

**7.** Assemblage selon la revendication 6, dans lequel ledit support comprend un mélange d'environ une partie de résine de diglycidyléther de bisphénol F et environ une partie de résine phénol époxy novolaque liquide et environ une partie d'un mélange de durcissant, de diluant et d'agent de couplage.

**8.** Assemblage selon la revendication 1, dans lequel ladite charge compte pour environ 63.1-76.8%.

**9.** Assemblage selon la revendication 8, dans lequel ladite charge est un mélange desdites particules de flocons, desdites particules d'agglomérats et desdites particules de poudre dans un rapport massique respectivement d'approximativement 40%, 30% et 30%.

**10.** Assemblage selon la revendication 9, dans lequel lesdites particules de poudre sont de l'argent.

**11.** Assemblage selon la revendication 9, dans lequel lesdites particules d'argent présentent une valeur FFSS d'environ 0,75 microns.

**12.** Assemblage selon la revendication 9, dans lequel lesdites particules de poudre présentent une taille moyenne de particules d'environ 1,6 microns.

**13.** Assemblage selon la revendication 1, dans lequel ledit substrat est flexible.

| | | | INITIAL @ | INITIAL @ | % | 15 HR | % | 24 HR @ | % | 39 HR @ | % | 63 HRS@ | % | 111 | % | EX IR 1000 | |
|---|---|---|---|---|---|---|---|---|---|---|---|---|---|---|---|---|---|
| | | | RM TEMP. | 60°C/90% RH | INCR | 60°C/90% RH | INCR | 60°C/90% RH | INCR | 60°C/90% RH | INCR | 60°C/90% RH | INCR | 60°C/90% RH | INCR | | |
| | | | | | | | | | | | | | | | | | |
| | | CHIP | 5:00 PM | 5:30 PM | | 9:00 AM | | 5:00 PM | | 9:00 AM | | 9:00 AM | | 10:00 AM | | | |
| | HEIGHT | | | | | | | | | | | | | | | 1000.000 | |
| | 68 | | 12.435 | 13.159 | 15.7 | 15.546 | 18.3 | 15.914 | 22.1 | 16.269 | 25.7 | 16.128 | 30.4 | 15.296 | 33.9 | 34.648 | 214.0 |
| 140°C/10m/IR | res | | 25.669 | 26.238 | 34.1 | 26.302 | 2.9 | 26.294 | 2.5 | 26.287 | 2.2 | 26.29 | 2.3 | 25.97 | 18.00 | 26.407 | 7.6 |
| | 44 | | 7.367 | 8.217 | 19.5 | 10.116 | 36.4 | 10.214 | 38.3 | 10.324 | 40.4 | 10.401 | 41.9 | 9.442 | 47.5 | 13.407 | 99.5 |
| | | | | | | | | | | | 36.6 | | | | | | |
| | 68 | | | | | | | | | | | | | | | | |
| 140°C/10m/IR | res | | | | | | | | | | | | | | | | |
| | 44 | | 6.961 | 7.657 | 17.6 | 9.126 | 31.5 | 9.276 | 34.8 | 9.362 | 36.6 | 9.473 | 39.00 | 8.6611 | 42.9 | 13.801 | 132.1 |

FIG. 1

F I G. 2

|  |  |  | INITIAL @ | INITIAL @ | % | 17 HR @ | % | 40 HR @ | % | 112 HR @ | % | 306 HR @ | % | 618 HR @ | % |
|---|---|---|---|---|---|---|---|---|---|---|---|---|---|---|---|
| ACETONE |  |  | RM TEMP. | 60°C/90% RH | INCR | 60°C/90% RH | INCR | 60°C/90% RH | INCR | 60°C/90% RH | INCR | 60°C/90% RH | INCR | 60°C/90% RH | INCR |
| CLEANED |  |  |  |  |  | 10/26/89 |  |  |  |  |  |  |  |  |  |
|  |  | CHIP | 4:30 PM | 5:00 PM |  | 10:00 AM |  | 10:00 AM |  | 10:00 AM |  | 12:30 PM |  |  |  |
|  |  | HEIGHT |  |  |  |  |  |  |  |  |  |  |  |  |  |
|  | 68 | 9.0 | 11.41 | 12.35 | 12.1 | 12.12 | 0.4 | 12.23 | 1.4 | 12.21 | -1.7 | 12.12 | -2.8 | 12.10 | -3.0 |
| 140°C/ 10 MIN | res |  | 1.42 | 1.54 | 9.1 | 1.56 | 1.4 | 1.48 | 4.2 | 1.46 | -5.6 | 1.46 | -5.6 | 1.46 | -5.6 |
|  | 44 | 3.0 | 7.22 | 7.76 | 12.8 | 7.10 | 1.9 | 7.52 | 5.0 | 7.46 | -6.3 | 7.43 | -6.9 | 7.42 | -7.1 |
|  |  |  |  |  |  |  |  |  |  |  |  |  |  |  |  |
|  | 68 | 3.0 | 13.48 | 14.52 | 11.0 | 14.64 | 1.1 | 14.64 | 1.1 | 14.64 | 1.1 | 14.49 | -0.3 | 14.59 | 0.1 |
| 140°C/ 10 MIN | res |  | 1.30 | 1.40 | 8.3 | 1.44 | 3.1 | 1.43 | 2.3 | 1.42 | 1.5 | 1.42 | 1.5 | 1.43 | 2.3 |
|  | 44 | 4.0 | 7.66 | 8.28 | 13.3 | 8.30 | 0.4 | 8.38 | 1.9 | 8.41 | 2.5 | 6.30 | 0.4 | 8.34 | 1.1 |
|  |  |  |  |  |  |  |  |  |  |  |  |  |  |  |  |
|  | 68 | 5.5 | 10.37 | 11.26 | 14.3 | 11.12 | 2.2 | 11.14 | 1.9 | 11.16 | -1.6 | 11.22 | -0.8 | 11.15 | -1.8 |
| 140°C/ 10 MIN | res |  | 1.37 | 1.49 | 9.4 | 1.55 | 4.3 | 1.50 | 0.7 | 1.51 | 1.4 | 1.52 | 2.2 | 1.50 | 0.7 |
|  | 44 | 2.8 | 6.34 | 6.88 | 16.2 | 6.75 | 3.4 | 6.75 | 3.4 | 6.76 | -3.1 | 6.74 | -3.6 | 6.67 | 5.4 |
|  |  |  |  |  |  |  |  |  |  |  |  |  |  |  |  |
|  | 68 | 2.5 | 11.52 | 10.79 | 12.9 | 12.64 | 1.8 | 12.68 | 2.2 | 12.72 | 2.7 | 12.67 | 2.1 | 12.79 | 3.5 |
| 140°C/ 10 MIN | res |  | 1.41 | 1.53 | 9.2 | 1.55 | 1.4 | 1.53 | 0.0 | 1.54 | 0.7 | 1.52 | -0.7 | 1.51 | -1.4 |
|  | 44 | 3.3 | 7.63 | 6.26 | 13.6 | 8.35 | 1.7 | 8.38 | 2.3 | 8.41 | 2.9 | 6.35 | 1.7 | 6.34 | 1.5 |
|  |  |  |  |  |  |  |  |  |  |  |  |  |  |  |  |
|  | 68 | 3.0 | 10.11 | 10.79 | 11.1 | 10.79 | 0.0 | 10.76 | 0.4 | 10.75 | -0.6 | 10.70 | -1.3 | 10.66 | -1.9 |
| 140°C/ 10 MIN | res |  | 1.40 | 1.52 | 9.2 | 1.57 | 3.5 | 1.60 | 5.6 | 1.61 | 6.3 | 1.62 | 7.0 | 1.65 | 9.2 |
|  | 44 | 2.0 | 6.30 | 6.87 | 17.3 | 6.82 | 1.2 | 6.79 | 2.1 | 6.78 | -2.3 | 6.71 | -4.1 | 6.68 | -4.9 |
|  |  |  |  |  |  |  |  |  |  |  |  |  |  |  |  |
|  | 68 | 5.5 | 9.95 | 10.85 | 15.1 | 10.84 | 0.1 | 10.77 | 1.2 | 10.76 | -1.3 | 10.71 | -2.0 | 10.61 | -3.5 |
| 140°C/ 10 MIN | res |  | 1.38 | 1.50 | 9.4 | 1.53 | 2.1 | 1.54 | 2.9 | 1.54 | 2.9 | 1.54 | 2.9 | 1.55 | 3.6 |
|  | 44 | 2.0 | 6.09 | 6.63 | 17.5 | 6.58 | 1.4 | 6.61 | 0.6 | 6.62 | -0.3 | 6.64 | 0.3 | 6.52 | -3.0 |

FIG.3A
SHEET 1/2

| 1002 HR @ | % | |
|---|---|---|
| 60°C/90% RH | INCR | 60 |
| | | |
| | | |
| | | |
| 12.15 | 2.4 | |
| 1.41 | -9.0 | |
| 7.41 | -7.4 | |
| | | |
| 14.82 | 2.9 | |
| 1.47 | 5.4 | |
| 6.41 | 2.5 | |
| | | |
| 11.34 | 0.8 | |
| 1.54 | 3.6 | |
| 6.70 | 4.6 | |
| | | |
| 13.00 | 6.0 | |
| 1.51 | -1.4 | |
| 8.42 | 3.0 | |
| | | |
| 10.77 | 0.3 | |
| 1.68 | 11.3 | |
| 6.68 | -4.9 | |
| | | |
| 10.65 | -2.9 | |
| 1.56 | 4.3 | |
| 6.61 | 0.6 | |

FIG. 3A
SHEET 2/2

| INORGANIC ACID | | CHIP HEIGHT | INITIAL @ RM TEMP | INITIAL @ 60 C/90% RH | % INCR | 14.5 HR@ 60 C/90% RH | % INCR | 117.5 HR@ 60 C/90% RH | % INCR | 149 HR@ 60 C/90% RH |
|---|---|---|---|---|---|---|---|---|---|---|
| | | | 5:00 PM | 6:00 PM | | 8:30 AM | | 4:30 PM | | 11:00 AM |
| | 68 | 4 | 10.440 | 11.240 | 12.4 | 11.120 | 1.7 | 11.030 | -2.9 | 11.030 |
| 140 C/ 10 MIN | res | | | | | | | | | |
| | 44 | 2 | 5.950 | 6.400 | 15.3 | 6.350 | -1.5 | 6.310 | -2.6 | 6.310 |
| | 68 | 3 | 9.030 | 9.780 | 14.9 | 9.720 | -1.0 | 9.670 | -1.9 | 9.670 |
| 140 C/ 10 MIN | res | | | 25.510 | 13.5 | 25.550 | 2.6 | 25.540 | 2.0 | 25.540 |
| | 44 | 1.3 | 6.630 | 7.150 | 14.3 | 7.100 | -1.2 | 7.070 | -1.9 | 7.070 |
| | 68 | 2.8 | 10.650 | 11.550 | 13.5 | 11.530 | -0.3 | 11.700 | -1.1 | 11.470 |
| 140 C/ 10 MIN | res | | | | | | | | | |
| | 44 | 1.8 | 7.040 | 7.620 | 14.4 | 4.610 | -0.2 | 7.570 | -1.1 | 7.570 |
| | 68 | 2.5 | 9.720 | 10.560 | 14.7 | 10.530 | -0.5 | 10.500 | -0.9 | 10.500 |
| 140 C/ 10 MIN | res | | | 25.310 | 15.9 | 25.390 | 6.1 | 25.390 | 6.1 | 25.390 |
| | 44 | 2.8 | 5.680 | 6.160 | 17.9 | 6.120 | -1.3 | 6.080 | -2.5 | 6.080 |
| | 68 | 2 | | | | | | | | |
| 140 C/ 10 MIN | res | | | | | | | | | |
| | 44 | 0.5 | | | | | | | | |
| | 68 | 3 | 10.230 | 11.040 | 13.0 | 10.980 | -0.9 | 10.910 | -1.8 | 10.910 |
| 140 C/ 10 MIN | res | | 25.180 | 25.370 | 16.1 | 25.390 | 1.5 | 25.390 | 1.5 | 25.390 |
| | 44 | 2.5 | 7.340 | 7.900 | 12.9 | 7.850 | -1.0 | 7.800 | -2.0 | 7.800 |

FIG. 3B SHEET 1/2

| % INCR | 297 HR@ 60 C/90% RH | % INCR | 969 HR@ 60 C/90% RH | % INCR |
|---|---|---|---|---|
| | 3:00 PM | | 2:30 PM | |
| -2.9 | 10.96 | -3.9 | 10.86 | -5.2 |
| -2.6 | 6.27 | -3.8 | 6.25 | -4.4 |
| -1.9 | 9.6 | -3.1 | 9.53 | -4.3 |
| 2.0 | 25.52 | 0.7 | 25.56 | 3.3 |
| -1.9 | 7.04 | -2.7 | 6.98 | -4.1 |
| -1.1 | 11.45 | -1.3 | 11.44 | -1.5 |
| -1.1 | 7.55 | -1.5 | 4.47 | -3.2 |
| -0.9 | 10.45 | -1.7 | 10.41 | -2.3 |
| 6.1 | 25.4 | 6.9 | 25.47 | 12.2 |
| -2.5 | 6.04 | -3.8 | 5.96 | -6.3 |
| -1.8 | 10.88 | -2.3 | 10.89 | 2.1 |
| 1.5 | 25.38 | 0.7 | 25.34 | 2.2 |
| -2.0 | 7.79 | -2.2 | 7.86 | 0.8 |

FIG. 3B
SHEET 2/2

| | | | INITIAL @ | INITIAL @ | % | 15 HR @ | % | 65 HR | % | 141 HR @ | % |
|---|---|---|---|---|---|---|---|---|---|---|---|
| 4.5 % | | | RM TEMP. | 60°C/90% RH | INCR | 60°C/90% RH | INCR | 60°C/90% RH | INCR | 60°C/90% RH | INCR |
| | | | | | | | | | | | |
| | | CHIP | 5:00 PM | 5:30 PM | | 8:30 PM | | 10:00 AM | | 2:00 PM | |
| | | HEIGHT | | | | | | | | | |
| | 68 | 4.0 | 10.45 | 11.40 | 14.7 | 11.34 | -0.8 | 11.32 | -1.1 | 11.350 | 0.7 |
| 140°C/ 10 MIN | res | | 1.66 | 1.80 | 9.0 | 1.83 | 1.7 | 1.84 | 2.2 | 1.840 | 2.2 |
| | 44 | 1.0 | 6.47 | 7.03 | 16.1 | 7.04 | 0.2 | 7.04 | 0.2 | 7.060 | 0.7 |
| | | | | | | | | | | | |
| | 68 | 2.8 | 9.63 | 10.40 | 15.1 | 10.41 | -1.1 | 10.4 | -1.2 | 10.420 | 0.9 |
| 140°C/ 10 MIN | res | | 1.38 | 1.50 | 9.4 | 1.53 | 2.0 | 1.53 | 2.0 | 1.540 | 2.7 |
| | 44 | 0.5 | 5.51 | 6.01 | 19.9 | 5.99 | -0.7 | 5.98 | -1.0 | 5.990 | -0.7 |

FIG. 4

| | | | INITIAL @ | INITIAL @ | % | 62 HR | % | 136 HR | % | 1073 HR | % | 1598 HR | % |
|---|---|---|---|---|---|---|---|---|---|---|---|---|---|
| STEAMED 8 HRS | | | RM TEMP. | 60°C/90% RH | INCR | 60°C/90% RH | INCR | 60°C/90% RH | INCR | 60°C/90% RH | INCR | 60°C/90% RH | INCR |
| | | CHIP | 5:30 PM | 6:00 PM | | 8:00 AM | | 10:00 AM | | 11:00 AM | | 8:00 AM | |
| | | HEIGHT | | | | | | | | | | | |
| | 68 | | 32.170 | 34.060 | 6.7 | 32.210 | 6.2 | 31.270 | 9.3 | 31.400 | 8.8 | 31.890 | 7.2 |
| 140°C/ 10 MIN | res | | 1.940 | 2.090 | 8.2 | 2.210 | 6.0 | 2.200 | 5.5 | 2.250 | 1.9 | 2.280 | 3.8 |
| | 44 | | 18.910 | 20.100 | 7.5 | 19.020 | 6.3 | 18.680 | 8.3 | 19.020 | 6.3 | 19.310 | 4.6 |
| | 68 | | 36.570 | 38.630 | 6.3 | 35.640 | 8.6 | 34.600 | 11.6 | 34.390 | 12.2 | 34.960 | 10.6 |
| 140°C/ 10 MIN | res | | 2.100 | 2.250 | 7.5 | 2.370 | 5.6 | 2.410 | 7.4 | 2.620 | 11.0 | 2.670 | 11.3 |
| | 44 | | 21.580 | 50.320 | 154.7 | | | | | | | | |
| | 68 | | 68.290 | 71.430 | 4.9 | 66.810 | 6.9 | 63.200 | 12.2 | 63.240 | 12.1 | 64.680 | 10.0 |
| 140°C/ 10 MIN | res | | 2.040 | 2.180 | 7.2 | 2.490 | 14.9 | 2.500 | 15.4 | 2.660 | 7.1 | 2.740 | 10.0 |
| | 44 | | 31.880 | 33.430 | 5.4 | 31.460 | 6.5 | 30.710 | 8.9 | 31.740 | 5.6 | 32.480 | 3.1 |
| | 68 | | 52.940 | 55.370 | 5.0 | 55.720 | 0.7 | 51.230 | 8.1 | 51.270 | 8.6 | 52.680 | 3.1 |
| 140°C/ 10 MIN | res | | | | | | | | | | | | |
| | 44 | | 26.140 | 27.490 | 5.8 | 25.850 | 6.7 | 25.300 | 8.9 | 25.880 | 6.6 | 26.710 | 3.2 |
| | 68 | | 28.440 | 30.060 | 6.6 | 28.500 | 6.0 | 27.630 | 9.3 | 27.650 | 9.2 | 28.300 | 6.8 |
| 140°C/ 10 MIN | res | | 1.980 | 2.100 | 6.4 | 2.190 | 4.5 | 2.210 | 5.5 | 2.570 | 18.2 | 2.610 | 19.0 |
| | 44 | | 15.980 | 16.060 | 0.6 | | | 16.050 | 0.1 | 16.410 | 2.7 | 16.720 | 5.1 |
| | 68 | | 30.220 | 31.850 | 6.2 | 29.920 | 6.9 | 29.060 | 10 | 29.600 | 8.1 | 30.890 | 3.4 |
| 140°C/ 10 MIN | res | | 1.880 | 2.020 | 7.9 | 2.080 | 3.1 | 2.050 | 1.6 | 2.140 | 3.0 | 2.190 | 7.2 |
| | 44 | | 19.040 | 20.150 | 6.9 | 19.150 | 5.8 | 18.840 | 7.6 | 19.380 | 4.5 | 20.020 | 0.8 |

FIG. 5

| | | | INITIAL @ | INITIAL @ | % | 14 HR | % | 62 HR | % | 1025 HR | % | 1530 HR | % |
|---|---|---|---|---|---|---|---|---|---|---|---|---|---|
| | | | RM TEMP. | 60°C/90% R | INCR | 60°C/90% R | INCR | 60°C/90% R | INCR | 60°C/90% RH | INCR | 60°C/90% RH | INCR |
| | | | | | | | | | | | | | |
| | | CHIP | 7:00 PM | 7:30 PM | | 1:30 PM | | 8:30 AM | | 8:30 AM | | 1:30 PM | |
| | | HEIGHT | | | | | | | | | | | |
| | 68 | | 7.770 | 8.460 | 18.3 | 8.430 | -0.7 | 8.420 | -0.9 | 8.300 | -3.6 | 8.210 | -5.6 |
| 140°C/ 10 MIN | res | | 1.700 | 1.840 | 8.8 | 1.820 | -1.1 | 1.820 | -1.1 | 1.720 | -5.6 | 1.660 | -9.3 |
| | 44 | | 4.740 | 5.170 | 24.7 | 5.120 | -2.3 | 5.110 | -2.8 | 5.010 | -7.4 | 5.000 | -7.8 |
| | | | | | | | | | | | | | |
| | 68 | | 6.350 | 6.910 | 23.8 | 6.880 | -1.0 | 6.870 | -1.4 | 6.610 | -10.3 | 6.570 | -11.7 |
| 140°C/ 10 MIN | res | | 1.500 | 1.610 | 7.9 | 1.600 | -0.7 | 1.600 | -0.7 | 1.550 | -3.3 | 1.510 | -6.0 |
| | 44 | | 4.630 | 5.040 | 25.2 | 5.010 | -1.5 | 5.010 | -1.5 | 4.980 | -2.9 | 5.050 | 0.5 |
| | | | | | | | | | | | | | |
| | 68 | | 6.580 | 7.180 | 23.3 | 7.170 | -0.3 | 7.170 | -0.3 | 7.040 | -4.4 | 7.100 | 2.5 |
| 140°C/ 10 MIN | res | | 1.530 | 1.660 | 9.1 | 1.650 | -0.6 | 1.650 | -0.6 | 1.590 | -3.9 | 1.550 | 6.5 |
| | 44 | | 4.550 | 4.980 | 27.7 | 4.970 | -0.5 | 4.970 | -0.5 | 5.050 | 3.5 | 5.190 | 10.6 |
| | | | | | | | | | | | | | |
| | 68 | | 7.500 | 8.160 | 18.9 | 8.100 | -1.4 | 8.080 | -1.9 | 7.920 | -4.4 | 7.870 | -5.1 |
| 140°C/ 10 MIN | res | | 1.760 | 1.910 | 9.3 | 1.890 | -1.1 | 1.930 | 1.1 | 1.810 | -4.5 | 2.040 | 6.0 |
| | 44 | | 4.810 | 5.250 | 24.3 | 5.200 | -2.2 | 5.190 | -2.7 | 5.070 | -8.0 | 5.010 | -10.7 |
| | | | | | | | | | | | | | |
| | 68 | | 7.100 | 8.500 | 45.2 | 8.520 | 0.4 | 8.530 | 0.7 | 8.540 | 0.9 | 8.720 | 4.9 |
| 140°C/ 10 MIN | res | | 1.630 | 1.760 | 8.5 | 1.760 | 0.0 | 1.800 | 2.4 | 1.650 | -6.6 | 1.620 | -10.6 |
| | 44 | | | | | | | | | | | | |
| | | | | | | | | | | | | | |
| | 68 | | | | | | | | | | | | |
| 140°C/ 10 MIN | res | | 1.550 | 1.68. | 9.0 | 1.670 | -0.6 | 1.670 | -0.6 | 1.660 | -0.6 | 1.760 | 5.7 |
| | 44 | | 4.250 | 4.640 | 31.2 | 4.600 | -2.4 | 4.600 | -2.4 | 4.520 | -7.3 | 4.510 | 7.9 |

FIG. 6

| | | | INITIAL @ | INITIAL @ | % | 14 HR | % | 62 HR | % | 1025 HR | % |
|---|---|---|---|---|---|---|---|---|---|---|---|
| IPA CLEANED | | | RM TEMP. | 60°C/90% RH | INCR | 60°C/90% RH | INCR | 60°C/90% RH | INCR | 60°C/90% RH | INCR |
| | | CHIP | 6:00 PM | 6:30 PM | | 8:30 AM | | 8:30 AM | | 11:00 AM | |
| | | HEIGHT | | | | | | | | | |
| | 68 | | 7.710 | 8.310 | 16.2 | 8.220 | -2.1 | 8.090 | -5.1 | 7.850 | -10.7 |
| 140°C/ 10 MIN | res | | 1.540 | 1.640 | 6.9 | 1.620 | -1.3 | 1.610 | -1.9 | 1.630 | 0.7 |
| | 44 | | 4.930 | 5.310 | 19.7 | 5.240 | -3.0 | 5.150 | -6.9 | 4.970 | -14.7 |
| | | | | | | | | | | | |
| | 68 | | 7.470 | 8.120 | 18.7 | 8.090 | -0.7 | 8.010 | -2.7 | 7.820 | -7.3 |
| 140°C/ 10 MIN | res | | 1.500 | 1.610 | 7.9 | 1.600 | -0.7 | 1.590 | -1.3 | 1.590 | -0.7 |
| | 44 | | | | | | | | | | |
| | | | | | | | | | | | |
| | 68 | | 7.890 | 8.600 | 18.3 | 8.570 | -0.7 | 8.460 | -3.0 | 8.260 | -7.4 |
| 140°C/ 10 MIN | res | | 1.580 | 1.690 | 7.4 | 1.670 | -1.3 | 1.660 | -1.9 | 1.670 | 0.0 |
| | 44 | | 5.080 | 5.530 | 21.6 | 5.500 | -1.2 | 5.430 | -4.0 | 5.310 | -8.7 |
| | | | | | | | | | | | |
| | 68 | | 7.340 | 8.000 | 19.8 | 7.960 | -1.0 | 7.860 | -3.5 | 7.810 | -3.8 |
| 140°C/ 10 MIN | res | | 1.400 | 1.470 | 5.4 | 1.420 | -3.6 | 1.410 | -4.4 | 1.430 | 0.8 |
| | 44 | | 4.560 | 4.980 | 26.9 | 4.960 | -1.0 | 4.910 | -3.5 | 4.830 | -7.6 |
| | | | | | | | | | | | |
| | 68 | | 7.700 | 8.390 | 18.6 | 8.360 | -0.7 | 8.260 | -3.0 | 8.170 | -5.0 |
| 140°C/ 10 MIN | res | | 1.500 | 1.610 | 7.9 | 1.600 | -0.7 | 1.580 | -2.0 | 1.610 | 0.7 |
| | 44 | | 8.440 | 5.090 | 61.6 | 5.080 | -0.5 | 5.030 | -2.9 | 4.970 | -5.7 |
| | | | | | | | | | | | |
| | 68 | | 7.740 | 8.390 | 17.4 | 8.300 | -2.1 | 8.150 | -5.5 | 8.160 | -5.2 |
| 140°C/ 10 MIN | res | | 1.550 | 1.660 | 7.6 | 1.650 | -0.6 | 1.640 | -1.3 | 1.690 | 2.6 |
| | 44 | | 4.800 | 5.250 | 25.0 | 5.230 | -0.9 | 5.140 | -4.9 | 5.060 | -8.4 |

FIG. 7

| IPA CLEANED | | | INITIAL @ RM TEMP. | INITIAL @ 60°C/90% RH | % INCR | 15 HR 60°C/90% RH | % INCR | 191 HR 60°C/90% RH | % INCR | 981 HR 60°C/90% RH | % INCR |
|---|---|---|---|---|---|---|---|---|---|---|---|
| | | CHIP | 5:00 PM | 5:30 PM | | 8:30 AM | | 4:00 PM | | 2:00 PM | |
| | | HEIGHT | | | | | | | | | |
| | 68 | | | | | | | | | | |
| 140°C/ 10 MIN | res | | 1.480 | 1.560 | 5.800 | 1.540 | -1.400 | 1.410 | -10.300 | 1.480 | -4.2 |
| | 44 | | 4.320 | 4.660 | 25.800 | 4.640 | -1.200 | 4.360 | -18.100 | 4.770 | 6.6 |
| | 68 | | 6.830 | 7.330 | 17.700 | 7.170 | -4.800 | 6.720 | -18.300 | 7.110 | -6.6 |
| 140°C/ 10 MIN | res | | 1.480 | 1.560 | 5.800 | 1.550 | -0.700 | 1.420 | -9.600 | 1.500 | -3.4 |
| | 44 | | 4.340 | 4.700 | 26.900 | 4.670 | -1.800 | 4.420 | -16.500 | 4.760 | 3.5 |
| | 68 | | 6.920 | 7.520 | 20.500 | 7.450 | -2.000 | 7.030 | -13.900 | 7.520 | 0.0 |
| 140°C/ 10 MIN | res | | 1.440 | 1.520 | 6.000 | 1.510 | -0.700 | 1.370 | -10.600 | 1.430 | 5.7 |
| | 44 | | 4.270 | 4.640 | 29.100 | 4.620 | -1.200 | 4.390 | -15.200 | 4.780 | 8.5 |
| | 68 | | | | | | | | | | |
| 140°C/ 10 MIN | res | | 1.470 | 1.550 | 5.800 | 1.530 | -1.400 | 1.420 | -9.000 | 1.490 | -2.8 |
| | 44 | | 4.200 | 4.560 | 30.000 | 4.520 | -2.600 | 4.250 | -19.900 | 4.470 | -5.8 |
| | 68 | | 7.050 | 7.670 | 20.300 | 7.600 | -1.900 | 7.460 | -5.700 | 7.470 | -5.4 |
| 140°C/ 10 MIN | res | | 1.470 | 1.550 | 5.800 | 1.550 | -0.000 | 1.430 | -8.300 | 1.520 | -2.1 |
| | 44 | | 4.320 | 4.700 | 28.800 | 4.660 | -2.400 | 4.360 | -20.000 | 4.650 | -2.9 |
| | 68 | | | | | | | | | | |
| 140°C/ 10 MIN | res | | 1.470 | 1.540 | 5.100 | 1.510 | -2.100 | 1.400 | -9.700 | 1.530 | 1.4 |
| | 44 | | 4.230 | 4.580 | 28.500 | 4.540 | -2.500 | 4.200 | -24.100 | 4.450 | -8.2 |

FIG. 8

| | | | INITIAL @ | INITIAL @ | % | 119HR | % | 503 HR | % | 1146 HR | % |
|---|---|---|---|---|---|---|---|---|---|---|---|
| IPA CLEANED | | | RM TEMP. | 60°C/90% R | INCR | 60°C/90% R | INCR | 60°C/90% R | INCR | 60°C/90% RH | INCR |
| | | | | | | | | | | | |
| | | CHIP | 2:00 PM | 2:30 PM | | 1:00 PM | | 1:00 PM | | 8:00 AM | |
| | | HEIGHT | | | | | | | | | |
| | 68 | | 11.40 | 12.17 | 10.00 | 11.92 | 3.10 | 12.02 | 1.80 | 12.32 | 1.80 |
| 140°C/ 10 MIN | res | | 1.49 | 1.58 | 6.50 | 1.50 | 5.40 | 1.48 | 6.80 | 1.47 | 7.40 |
| | 44 | | | 0.00 | | | | | | | |
| | . | | 0.00 | | | | | | | | |
| | 68 | | 10.01 | 10.81 | 13.30 | 10.65 | 2.30 | 10.73 | 1.20 | 11.43 | 9.10 |
| 140°C/ 10 MIN | res | | 1.56 | 1.66 | 6.80 | 1.62 | 2.60 | 1.62 | 2.60 | 1.63 | 1.90 |
| | 44 | | 6.74 | 7.27 | 14.00 | 7.14 | 3.00 | 7.21 | 1.40 | 7.35 | 1.90 |
| | | | | | | | | | | | |
| | 68 | | 9.49 | 10.27 | 14.20 | 10.11 | 2.60 | 10.19 | 1.30 | 10.37 | 1.60 |
| 140°C/ 10 MIN | res | | 1.50 | 1.58 | 5.70 | 1.49 | 6.10 | 1.43 | 10.10 | 1.43 | 10.10 |
| | 44 | | 6.42 | 6.92 | 14.60 | 6.78 | 3.60 | 6.85 | 1.80 | 6.99 | 1.80 |
| | | | | | | | | | | | |
| | 68 | | | | | | | | | | |
| 140°C/ 10 MIN | res | | 1.38 | 1.47 | 7.00 | 1.43 | 2.90 | 1.41 | 4.40 | 1.41 | 4.40 |
| | 44 | | 5.57 | 6.03 | 17.90 | 5.95 | 2.60 | 6.03 | 0.00 | 6.17 | 4.60 |
| | | | | | | | | | | | |
| | 68 | | 11.76 | 12.64 | 11.30 | 12.64 | 0.00 | 12.82 | 2.10 | 13.18 | 6.20 |
| 140°C/ 10 MIN | res | | 1.40 | 1.49 | 6.90 | 1.45 | 2.90 | 1.44 | 3.60 | 1.43 | 4.30 |
| | 44 | | 9.39 | 7.75 | 25.70 | 7.87 | 2.50 | 7.94 | 4.00 | 8.50 | 15.80 |
| | | | | | | | | | | | |
| | 68 | | 11.14 | 11.93 | 11.10 | 11.98 | 0.60 | 12.16 | 2.90 | 12.51 | 7.30 |
| 140°C/ 10 MIN | res | | 1.58 | 1.66 | 5.40 | 1.57 | 5.80 | 1.55 | 7.10 | 1.53 | 8.30 |
| | 44 | | 9.14 | 9.74 | 9.80 | 9.59 | 2.20 | 9.75 | 0.10 | 10.08 | 5.00 |

FIG. 9

| IPA CLEANED | | | INITIAL @ RM TEMP. | INITIAL @ 60 C/90% RH | % INCR | 65 HR 60 C/90% RH | % INCR | 453 HR 60 C/90% RH | % INCR | 1096 HR 60 C/90% RH | % INCR |
|---|---|---|---|---|---|---|---|---|---|---|---|
| | | | | | | | | | | | |
| | | CHIP | 4:00 PM | 4:30 PM | | 9:00 AM | | 1:00 PM | | 8:00 AM | |
| | | HEIGHT | | | | | | | | | |
| | 68 | | | | | | | | | | |
| 140 C/ 10 MIN | res | | 1.490 | 1.610 | 8.6 | 1.590 | -1.3 | 1.550 | -4.0 | 1.540 | -4.6 |
| | 44 | | 8.690 | 9.410 | 12.7 | 9.530 | 1.9 | 9.690 | 4.4 | 10.330 | 14.4 |
| | | | | | | | | | | | |
| | 68 | | 15.460 | 16.690 | 10.7 | 16.630 | -0.5 | 16.610 | -0.6 | 17.120 | 3.4 |
| 140 C/ 10 MIN | res | | 1.450 | 1.560 | 8.1 | 1.530 | -2.1 | 1.490 | -4.8 | 1.490 | -4.8 |
| | 44 | | 11.770 | 12.650 | 10.0 | 12.600 | -0.5 | 12.710 | 0.6 | 13.230 | 6.0 |
| | | | | | | | | | | | |
| | 68 | | 11.890 | 12.920 | 13.1 | 13.020 | 1.1 | 13.100 | 2.0 | 13.550 | 7.1 |
| 140 C/ 10 MIN | res | | 1.570 | 1.700 | 8.8 | 1.670 | -1.9 | 1.640 | -3.8 | 1.630 | -4.4 |
| | 44 | | 7.860 | 8.550 | 14.2 | 8.560 | 0.2 | 8.680 | 2.3 | 9.210 | 11.9 |
| | | | | | | | | | | | |
| | 68 | | 16.270 | 17.550 | 10.4 | 17.520 | -0.2 | 17.460 | -0.7 | 17.910 | 2.7 |
| 140 C/ 10 MIN | res | | 1.490 | 1.600 | 7.9 | 1.570 | -2.0 | 1.530 | -4.7 | 1.530 | -4.7 |
| | 44 | | 11.500 | 12.400 | 10.6 | 12.250 | -1.6 | 12.220 | -1.9 | 12.600 | 2.1 |
| | | | | | | | | | | | |
| | 68 | | 11.090 | 12.060 | 13.7 | 11.980 | -1.0 | 11.890 | -2.1 | 11.980 | -1.0 |
| 140 C/ 10 MIN | res | | 1.440 | 1.560 | 9.0 | 1.520 | -2.7 | 1.470 | -6.2 | 1.470 | -6.2 |
| | 44 | | 7.150 | 7.770 | 14.9 | 7.660 | -2.3 | 7.620 | -3.1 | 7.810 | 0.8 |
| | | | | | | | | | | | |
| | 68 | | 10.960 | 11.930 | 13.9 | 11.890 | -0.5 | 11.860 | -0.9 | 12.030 | 1.3 |
| 140 C/ 10 MIN | res | | 1.410 | 1.530 | 9.2 | 1.510 | -1.4 | 1.490 | -2.8 | 1.480 | -3.5 |
| | 44 | | 8.290 | 9.000 | 13.4 | 8.970 | -0.5 | 9.080 | 1.3 | 9.500 | 8.3 |

FIG. 10

|  |  |  | INITIAL @ | INITIAL @ | % | 65 HR | % | 453 HR | % | 1096 HR | % |
|---|---|---|---|---|---|---|---|---|---|---|---|
| IPA CLEANED |  |  | RM TEMP. | 60°C/90% RH | INCR | 60°C/90% RH | INCR | 60°C/90% RH | INCR | 60°C/90% RH | INCR |
|  |  |  |  |  |  |  |  |  |  |  |  |
|  |  | CHIP | 4:00 PM | 4:30 PM |  | 9:30 AM |  | 1:00 PM |  | 8:00 AM |  |
|  |  | HEIGHT |  |  |  |  |  |  |  |  |  |
|  | 68 |  | 13.720 | 14.850 | 11.6 | 14.800 | -0.5 | 15.030 | 1.7 | 15.830 | 9.0 |
| 140°C/ 10 MIN | res |  | 1.520 | 1.650 | 9.2 | 1.680 | 1.9 | 1.740 | 5.8 | 1.830 | 9.5 |
|  | 44 |  | 8.520 | 9.220 | 12.7 | 9.340 | 1.9 | 9.600 | 6.1 | 10.210 | 15.9 |
|  |  |  |  |  |  |  |  |  |  |  |  |
|  | 68 |  | 12.620 | 13.550 | 10.8 | 13.810 | 2.7 | 14.190 | 6.7 | 15.040 | 15.6 |
| 140°C/ 10 MIN | res |  | 1.540 | 1.680 | 9.7 | 1.680 | 0.0 | 1.670 | -0.6 | 1.700 | 1.3 |
|  | 44 |  |  |  |  |  |  |  |  |  |  |
|  |  |  |  |  |  |  |  |  |  |  |  |
|  | 68 |  | 10.170 | 11.110 | 15.2 | 11.260 | 2.1 | 11.520 | 5.8 | 12.040 | 13.1 |
| 140°C/ 10 MIN | res |  | 1.570 | 1.700 | 8.8 | 1.700 | 0.0 | 1.680 | -1.3 | 1.690 | -0.6 |
|  | 44 |  | 6.930 | 7.540 | 15.5 | 7.540 | 0.0 | 7.640 | 2.2 | 7.910 | 8.1 |
|  |  |  |  |  |  |  |  |  |  |  |  |
|  | 68 |  | 9.220 | 10.090 | 16.7 | 10.170 | 1.3 | 10.330 | 3.9 | 10.660 | 7.9 |
| 140°C/ 10 MIN | res |  | 1.540 | 1.660 | 8.3 | 1.690 | 1.9 | 1.750 | 5.8 | 1.910 | 13.8 |
|  | 44 |  | 5.940 | 6.470 | 18.0 | 6.460 | -0.3 | 6.570 | 2.9 | 6.750 | 8.1 |
|  |  |  |  |  |  |  |  |  |  |  |  |
|  | 68 |  | 8.790 | 9.600 | 16.9 | 9.610 | 0.2 | 9.680 | 1.4 | 9.950 | 6.2 |
| 140°C/ 10 MIN | res |  | 1.480 | 1.610 | 9.4 | 1.630 | 1.3 | 1.630 | 1.3 | 1.670 | 2.6 |
|  | 44 |  | 5.530 | 6.030 | 19.8 | 6.070 | 1.3 | 6.190 | 5.3 | 6.410 | 12.5 |
|  |  |  |  |  |  |  |  |  |  |  |  |
|  | 68 |  | 8.900 | 9.710 | 16.5 | 9.740 | 0.5 | 9.890 | 3.2 | 10.150 | 7.7 |
| 140°C/ 10 MIN | res |  | 1.500 | 1.620 | 8.6 | 1.620 | 0.0 | 1.600 | -1.3 | 1.620 | 0.0 |
|  | 44 |  | 6.670 | 7.240 | 15.5 | 7.260 | 0.5 | 7.410 | 4.0 | 7.730 | 11.6 |

FIG.11

| TUF-1.56 | | | INITIAL @ | INITIAL @ | % | 1031 HR | % |
|---|---|---|---|---|---|---|---|
| | | | RM TEMP. | 60 C/90% RH | INCR | 60 C/90% RH | INCR |
| | | | 7/25/90 | 7/25/90 | | 9/6/90 | |
| | | CHIP | 4:00 PM | 5:00 PM | | 4:00 PM | |
| | | HEIGHT | | | | | |
| 1 | 68 | 5.5 | 28.130 | 29.970 | 7.6 | 27.850 | -8.2 |
| 140 C/ 10 MIN | res | | 5.770 | 6.250 | 8.5 | 2.500 | -61 |
| | 44 | 0.5 | 20.710 | 21.730 | 5.8 | 18.270 | -18.5 |
| | | | | | | | |
| 2 | 68 | 2.5 | 23.800 | 25.230 | 7.2 | 20.430 | -22.6 |
| 140 C/ 10 MIN | res | | 1.230 | 1.430 | 17.7 | 1.400 | -2.3 |
| | 44 | 1.5 | 13.810 | 14.230 | 3.9 | 12.680 | -13.8 |
| | | | | | | | |
| 3 | 68 | 3.3 | 25.540 | 26.990 | 6.7 | 20.730 | -27.2 |
| 140 C/ 10 MIN | res | | 1.050 | 1.270 | 23.2 | 1.250 | -1.7 |
| | 44 | 1.0 | 11.520 | 12.420 | 10.6 | 11.140 | -13.6 |

FIG. 12

| CAL POLYMER | | | INITIAL @ | INITIAL @ | % | 429.5 HR | % |
|---|---|---|---|---|---|---|---|
| W/1.05% | | | RM TEMP. | 60 C/90% RH | INCR | 60 C/90% RH | INCR |
| | | | | | | | |
| | | CHIP | 5:00 PM | 6:00 PM | | 3:30 PM | |
| | | HEIGHT | | | | | |
| 1 | 68 | 3.8 | 26.840 | 29.270 | 10.6 | 25.770 | -13.9 |
| 140 C/ 10 MIN | res | | 3.230 | 3.700 | 15.0 | 3.660 | -1.1 |
| | 44 | 4.5 | 14.810 | 16.170 | 11.5 | 14.420 | -13.3 |
| | | | | | | | |
| 2 | 68 | 5.3 | 24.540 | 26.350 | 8.8 | 22.960 | -15.2 |
| 140 C/ 10 MIN | res | | 3.070 | 3.560 | 16.5 | 3.520 | -1.2 |
| | 44 | 4.0 | 14.250 | 15.780 | 13.6 | 14.200 | -12.4 |

FIG. 13

| SR900 | | | INITIAL @ | INITIAL @ | % | 192.5 HR | % |
|---|---|---|---|---|---|---|---|
| | | | RM TEMP. | 60 C/90% RH | INCR | 60 C/90% RH | INCR |
| | | | 9/24/90 | 9/24/90 | | 10/2/90 | |
| | | CHIP | 2:00 PM | 3:30 PM | | 4:00 PM | |
| | | HEIGHT | | | | | |
| 1 | 68 | 2.5 | 42.540 | 90.490 | 124.4 | 95.79 | 6.1 |
| 140 C/ 30 MIN | res | | 3.310 | 3.910 | 18.7 | 4.07 | 4.2 |
| | 44 | 4.0 | 22.480 | 52.850 | 155.9 | 48.5 | -8.7 |
| | | | | | | | |
| 2 | 68 | 2.5 | 42.280 | 79.000 | 95.9 | 85.49 | 8.7 |
| 140 C/ 30 MIN | res | | 2.940 | 3.690 | 26.4 | 3.91 | 6.1 |
| | 44 | 4.0 | 26.020 | 61.170 | 152.7 | 51.15 | -17.2 |
| | | | | | | | |
| 3 | 68 | 3.0 | 57.860 | 104.670 | 86.9 | | |
| 140 C/ 30 MIN | res | | | | | | |
| | 44 | 1.5 | 26.300 | 101.900 | 324.5 | 57.05 | -45.3 |

FIG. 14